# EUROPEAN PATENT SPECIFICATION

(11) **EP 4 493 972 B1**
(45) Date of publication and mention of the grant of the patent: **05.08.2026**
(21) Application number: 23715762.3
(22) Date of filing: 15.03.2023
(51) Int. Cl.: G02B 19/00, F21V 8/00

(54) **LIGHT COLLECTING ASSEMBLY**
LICHTSAMMELANORDNUNG
ENSEMBLE DE COLLECTE DE LUMIÈRE

(30) Priority: 15.03.2022 WO PCT/EP2022/056756
(43) Date of publication of application: 22.01.2025
(73) Proprietor: Freshape SA, 1020 Renens (CH)
(72) Inventor: UNUCHEK, Dmitrii, 1024 Ecublens (CH); LIU, Yuhang, 1024 Ecublens (CH); PANUSA, Giulia, 1024 Ecublens (CH); CUCCATO, Nicola, 1024 Ecublens (CH); RUBI, Mathieu, 1024 Ecublens (CH)
(74) Representative: Schneiter, Sorin
(86) International application number: PCT/EP2023/056662
(87) International publication number: WO 2023/175034

(56) References cited:
- US-A1- 2011 011 449
- US-A1- 2011 096 426

## Description

### Technical Field

The present invention generally relates to the field of light collecting and/or distributing devices and assemblies. The invention more specifically relates to light collecting and/or light concentrating assemblies.

### Background Art and Problems Solved by the Invention

Almost all of the Earth's energy input comes from the sun. It can be calculated that the amount of energy reaching the surface of the Earth every hour via terrestrial solar radiation is greater than the amount of energy used by the Earth's population over an entire year. Consequently, it has been a challenge to capture solar energy and to render the energy exploitable by humans.

Photovoltaic (PV) cells have been widely used to convert sunlight energy into electrical power. There are many different types and technology of PV cells, of which many are characterized by manufacturing processes that are costly and require large amounts of energy by themselves. This applies in particular to high efficiency PV cells.

In order to more efficiently capture solar light and reduce the costs of gaining electrical energy by high efficiency PV cells, a light collecting and illumination apparatus has been disclosed in US 2010/0278480 A1. This apparatus comprises a planar light collecting array comprising lenses and a planar waveguide, configured to conduct light by means of optical transmission and total internal reflection (TIR) towards a central portion of the waveguide, where a photovoltaic cell is provided.

Similar solutions having the same overall operation principle are disclosed in US 2018/0054159, US 9,337,373 and US 2011/0096426. US 2011/0011449 discloses a dual-axis sun tracking system.

An aspect that is not addressed in the indicated references is the problem of the inclination of the sunlight that is to be captured. The angle of the light impinging on a generally light collecting device varies in dependency of the latitude on Earth, of the season and also on a daily schedule due to the earth's rotational movement. One obvious way to address this problem is to adapt the spatial orientation of the light capturing device, preferably in an automated manner, such that the planar device is always orthogonal with respect to the incoming sunlight. The implementation of automated displacement and tracking systems imply a substantial mechanical burden and can therefore not be implemented easily or everywhere.

EP 3 549 257 B1 discloses an optomechanical system comprising an optical arrangement comprising a shifting mechanism for translationally moving at least one of the layers of the optical arrangement relative to a light absorbing substrate.

In view of EP 3 549 257 B1, the present invention seeks to reduce the mechanical burden associated with a relative movement between components of the system and to reduce the required movement in general. The invention also seeks to reduce the loss of light capturing area due to a horizontal shifting movement.

A general objective of the invention is to provide a solution for allowing a higher concentration of solar light, while preferably keeping the manufacturing and material related costs as low as possible. The invention also seeks to render the resource of solar and/or environmental light available and exploitable in general, not necessarily only for use with a PV module and the generation of electricity. It is a further objection of the invention to provide a waveguide device that improves light capturing and transport efficiency, preferably using less material input, and exhibits less loss of light. It is also an objective to reduce the weight of the light collecting devices.

Further objectives and problems addressed by the present invention will become apparent from the description of the aspects and embodiments of the invention herein below.

### Summary of the Invention

Remarkably, the present inventors provide a light collecting assembly that can be implemented so as to achieve a high concentration of light and to render the light available for any desired further use. The assembly of the invention can be realized economically with relatively little and with low-cost materials. Furthermore, the assembly of the invention exhibits an improved ratio between the area on ground occupied by the assembly and the area that is available for light capturing.

In an aspect, the invention provides a light collecting assembly comprising: a focusing device comprising a focusing entity provided to receive external light and focus said external light to provide focused light; a waveguide subassembly comprising a waveguide unit provided to receive said focused light, wherein said waveguide unit comprises light deflective areas comprising: a group of incoming light (IL) deflective areas provided to receive and deflect said focused light so as to provide propagated light that is propagated within said waveguide unit; one or more transferring light (TL) deflective area provided to deflect said propagated light so as to provide an transfer light beam leaving said waveguide unit; wherein said waveguide unit comprises a junction region and/or an exit region, wherein said waveguide unit is suitable to provide said transfer light beam passing through said junction region and/or exit region to leave said waveguide unit; wherein one or both selected from said waveguide subassembly and said focusing device is provided rotational in said light collecting assembly, and wherein single-axis rotation, optionally in combination with a linear movement changing a distance (D) between said waveguide subassembly and said focusing device, is provided for solar light tracking; characterized in that said waveguide unit is provided so that, at a time, said focused light is received by (I) only one IL deflective area selected from said group of IL deflective areas, (II) said junction region, or (III) none of the IL deflective areas nor said junction region, and in that said IL deflective areas are provided such that a rotational position of said waveguide subassembly and/or said focusing device, is adjustable to determine if said focused light is received by (I) said only one IL deflective area, (II) said junction region, or (III) none of said IL deflective areas nor said junction region, and, in case said focused light is received by said only one IL deflective area, which IL deflective area of said group of IL deflective areas is said only one receiving said focused light.

In an aspect, the invention provides a method for operating the light collecting assembly of the invention, the method comprising conducting a single-axis rotational movement of said focusing device and/or of said a waveguide subassembly around an axis, optionally in combination with a linear movement of said waveguide subassembly along said axis, for solar light tracking.

In an embodiment, said light collecting assembly is configured to conduct tracking of external solar light in dependence of the incident light angle of said external light by redirection of the focused light from one of said IL deflective areas to another one of said IL deflective areas.

In a preferred embodiment of said light collecting assembly, said focusing entity comprises a lens with a part of the lens that possesses axial symmetry and/or wherein said lens exhibits more than 2-fold discrete rotational symmetry.

In a preferred embodiment of said light collecting assembly, an axis of rotation of one or both selected from said waveguide subassembly and said focusing device is substantially normal to the overall light collecting assembly and/or to first and second opposed sides of said waveguide subassembly.

In a preferred embodiment of said light collecting assembly, said group of IL deflective areas comprises separate IL deflective areas provided at separate positions with respect to said waveguide unit, wherein said positions are selected such that light impinging on said light focusing device at different incident angles (α, β, ...) or angle ranges is focused towards said one of said IL deflective areas, depending on the incident angle.

In a preferred embodiment, said waveguide unit comprises a plurality of non-overlapping light channels, each light channel extending from one IL deflective area to a TL deflective area, wherein said light channels extend radially from said junction region and wherein said waveguide unity comprises light channels having different lengths and extending in different directions, and preferably wherein said light channels are provided in the form of arms consisting essentially of a waveguide medium, said arms being joined at said junction region.

In a preferred embodiment, each waveguide unit comprises one or more waveguide exit providing a transfer light beam, wherein said waveguide subassembly comprises a plurality of waveguide units, and wherein said focusing device comprises a plurality of focusing entities, so that said waveguide subassembly is arranged to provide a plurality of transfer light beams for transferring light received via separate focusing entities propagated in separate waveguide units.

In a preferred embodiment of the method of the invention, said rotational movement is conducted so as to direct said focused light to one or more of said incoming light (IL) deflective areas, and so as to thereby preferably maximize the transfer of external light through said waveguide subassembly and/or waveguide subassemblies.

In a preferred embodiment of the method of the invention, said rotational movement is conducted so as to direct said focused light away from said incoming light (IL) deflective areas, so as to thereby let the light pass through the light collecting assembly and/or minimizing the redirection of light through said waveguide subassembly and/or waveguide subassemblies.

In a preferred embodiment of the method of the invention, said rotational movement comprises one or more selected from: a rotation of both, said focusing device and said waveguide subassembly, preferably by co-rotation around said axis; a rotation of one selected from said focusing device and said waveguide subassembly with respect to the other, said waveguide subassembly and focusing device, respectively.

In some embodiments, the assembly is suitable to collect, to concentrate and to redirect light so as to make concentrated light available for further transfer or any desired use.

Further preferred embodiments of the invention are defined herein below and in the appended claims. Further features and advantages of the invention will become apparent to the skilled person from the description of the preferred embodiments given below.

### Brief Description of the Drawings

**Figures 1A, 1B** and **1C** schematically show a first embodiment of the light collecting assembly of the invention.
**Figures 2A** and **2B** schematically show a second embodiment of the light collecting assembly of the invention.
**Figure 3** schematically shows a third embodiment of the light collecting assembly of the invention.
**Figures 4A** and **4B** show a light collecting assembly (Fig. 4B) and a waveguide unit thereof (Fig. 4A) according to a fourth embodiment of the invention.
**Figures 5A** illustrates the operation of the embodiment shown in Fig. 4B.
**Figure 5B** **is** a schematic top-down view of the embodiment shown in Fig. 4B.
**Figures 6A** and **6B** illustrate how a focus point or region is captured by way of the embodiment shown in Fig. 4B.
**Figure 7** illustrates a fifth embodiment of the assembly, configured to capture light with a large incident light angle, which is closer to horizontal.
**Figure 8** schematically shows a top-down view of a sixth embodiment of the invention.
**Figures 9A** and **9B** illustrate the problem of capturing light at a focus region and a solution provided in accordance with an embodiment of the invention.
**Figures 10** and **11** show embodiments of the invention, which may be combined with previously disclosed embodiments.
**Figures 12, 13A** and **13B** disclose two exemplary embodiments for providing a substantially circular support for a waveguide subassembly in accordance with embodiments. Fig. 13B is a section through the embodiment of Fig. 13A at line A-A.
**Figures 14A** and **14B** discloses the assembly shown in Fig. 4B and a suitable support frame according to an embodiment.
**Figures 15** and **16** disclose further embodiments of the invention, comprising several waveguide layers. These embodiments may be advantageously combined with embodiments elsewhere in this specification.

Hereinafter, preferred embodiments of the device and the assembly of the invention are described, in order to illustrate the invention, without any intention to limit the scope of the present invention.

### Detailed Description of the Preferred Embodiments

The present invention relates to a light collecting assembly. The assembly is suitable to collect incident light, and is particularly adapted to collect ambient and or sunlight, for example direct sunlight.

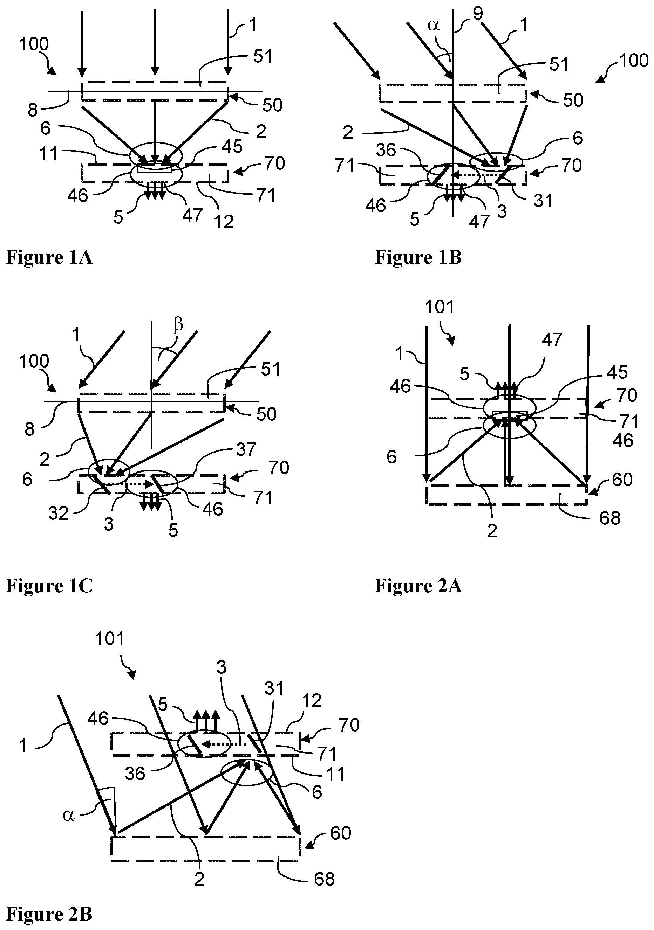

The assembly 100-104 of the invention comprises a focusing device 50, 60, each focusing device preferably comprising one or more focusing entity, 51, 52, 53, ... 68, . The focusing device preferably comprises at least one but preferably a plurality of focusing entities, for example from 2 to 10⁶, preferably 3 to 10⁴, more preferably 5 to 10³ and most preferably to 10² light focusing entities. The focusing entities may be transparent and focus light by way of refraction. In this case, the focusing entities 51 may comprise a lens or a lens system, preferably a converging lens, as shown in **Figures 1A-1C****.** The individual focusing entity 68 may also provide focused light 2 by being reflective, as illustrated by assembly 101 in **Figures 2A** and **2B****.** In this case, light focusing is achieved by a concave, reflective surface, for example a parabolic mirror.

Preferably, the focusing entity 51, 68 receives incident light 1 that impinges from the outside on the assembly, and converges the light towards a focal region or focal point 6. As a result of the convergence brought by the focusing entity 51, 68, the focal region preferably occupies a surface that is substantially smaller, when projected to a plane 8 that is substantially parallel to the focusing entity 51, than the area occupied by a single focusing entity.

In an embodiment, the assembly of the invention preferably comprises a plurality of focusing entities 51, 52, ... , 68, ... which are provided one next to the other, preferably adjacently. In an embodiment, the focusing entities 51, 52, ... of the focusing device are aligned in or with respect to a common plane 8. More generally, the focusing device is oriented or aligned in parallel with respect to a plane 8 such that a projection of the focusing entities, taken together, on that plane occupies a surface that is maximal, assuming that the projecting light is normal to plane 8.

Preferably, the focusing entity 51 provides focused light 2. The assembly of the invention preferably comprises a waveguide assembly or subassembly 70. The waveguide subassembly 70 preferably comprises one or more waveguide units 71, 72, .... In a preferred embodiment, the waveguide subassembly 70 and/or the waveguide units are oriented substantially in parallel to plane 8 and/or to the focusing device 50, 60.

Preferably, where the assembly 100, 101 comprises a plurality of light focusing entities and/or waveguide units, several and/or preferably all of said light focusing entities and/or waveguide units may, but need not necessarily, have overall similar or identical constructional features. If there are similar or identical constructional features, the description of features of a single entity or unit preferably also applies for the other entities or units, respectively.

Preferably, the number of waveguide units 71 is similar to and preferably corresponds to the number of focusing entities 51. Preferably, there is one waveguide unit per one focusing entity.

In an embodiment, one waveguide unit 71 is preferably provided to receive the focused light 2 focused by one focusing entity 51. In other embodiments, a waveguide unit may be provided to receive focused light of two or more separate focusing entities. Preferably, at one given moment in time, a waveguide unit is provided to receive focused light provided by one focusing entity.

Preferably, the waveguide unit comprises a plurality of light deflective areas 31-37, which preferably comprise one or more incoming light (IL) deflective areas and one or more transferring light (TL) deflective areas.

The waveguide unit 71 comprises a group of IL deflective areas 31-34. The IL deflective areas have the purpose of receiving light focused by the focusing entity 51, and to transfer it inside the waveguide unit, where the light is propagated. The IL deflecting areas 31-34 are preferably provided so as to provide propagated light 3, as shown in particular in Figs 1B, 1C and 2B. The propagated light 3 is light that is propagated preferably inside the waveguide unit. Preferably, the waveguide unit comprises or consists essentially of a medium that allows for the propagation of light, for example transparent glass or transparent plastic, PMMA or polycarbonate, for example. Preferably, the propagated light is propagated inside the waveguide unit 71 by internal reflection, preferably by exploiting the principle of total internal reflection (TIR).

Preferably, the waveguide medium comprises and/or consists essentially of a material that is suitable to transport light, preferably by internal reflection, such as TIR. In a preferred embodiment, the medium comprises and/or consists essentially of a material that has a refractive index that is larger than the refractive index of air. In a more general embodiment, the medium comprises and/or consists essentially of a material that has a relatively high refractive index and that can be surrounded by a material having a lower index of refraction.

Light deflective areas, such as IL and TL light deflective areas, may be provided in the form of an interface between the waveguide unit comprising the light deflective area and a surrounding medium, such as air. Due to the difference of the refractive indexes between the waveguide medium and the surrounding medium, for example the air, a deflection of light can be obtained, which can be controlled by the adjustment of the angle of the light deflective area with respect to the light that is to be deflected, and thus by the device configuration and/or orientation of the waveguide subassembly and in particular the IL and TL deflective areas.

Instead of a simple interface between two media having different refractive indexes, one or more light deflective areas may be provided by a reflective coating, which may be applied at the position where light deflection is desired. For example, the material of the waveguide subassembly may comprise a coating that is provided on an external surface of the waveguide structure to assure minimal losses on the coupling/redirecting of the light. In such a configuration, the redirection of light is not only enabled by the phenomenon of TIR, or is not limited to TIR, but by reflection more generally.

Furthermore, in some embodiments, parts or all of the waveguide may be covered with reflective coating to improve the guiding of light that is already inside the waveguide material. For example, a reflective coating may be applied in areas where TIR is not ensured or to improve overall light guiding efficiency. Reflective coatings are preferably applied on outer surfaces of the waveguide subassembly and/or material.

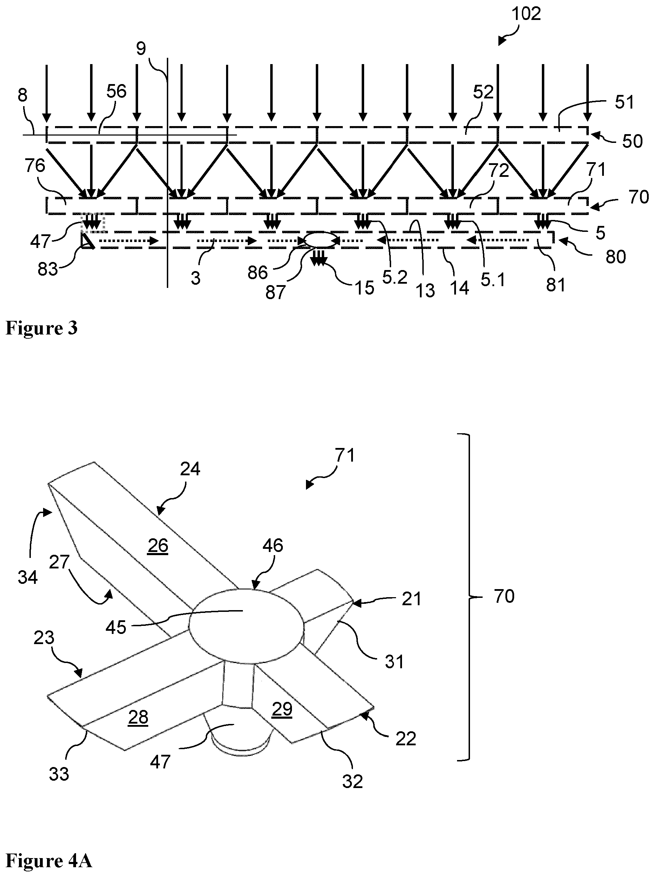

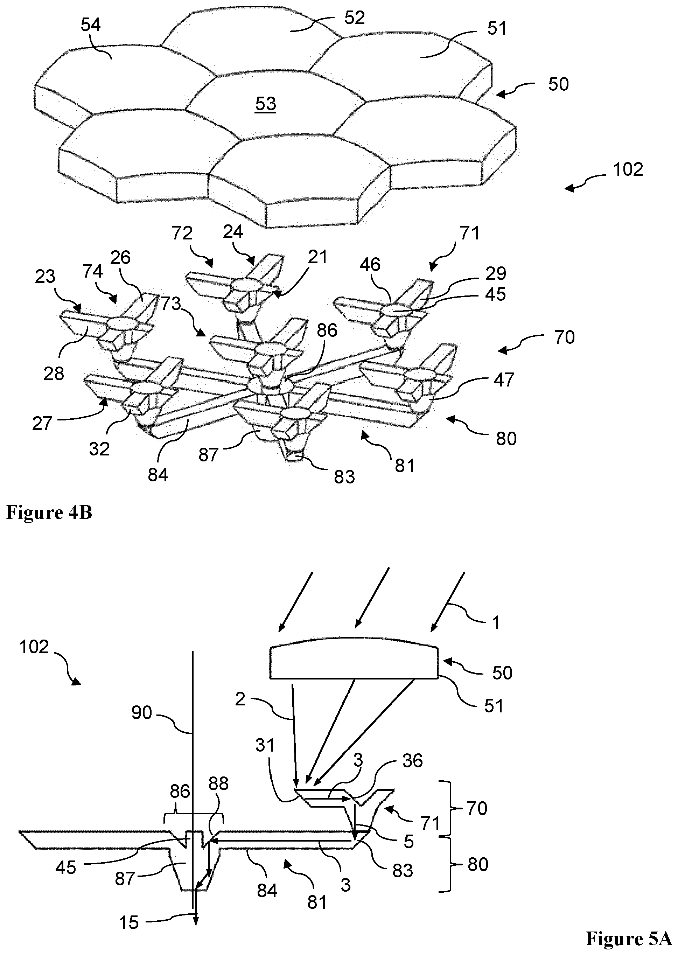

In an embodiment, said light deflective areas, such as said IL and/or or TL deflective areas, may, independently, be provided by a waveguide-air interface or by a reflective coating. The waveguide-air interface may be provided independently at a boundary and/or extremity of said waveguide material (see Figs 4A and/or 4B), and/or said interface may be provided inside a volume comprising a waveguide material, for example of said waveguide unit 71 (or another waveguide unit and/or subassembly).

In an embodiment, said light deflective areas, such as said IL and/or or TL deflective areas, may, independently, comprise surfaces that are coated with a reflective coating. Such coatings may be used to improve the transfer of the light, for example into the waveguide (IL deflective area) and the desired reflection of light inside the waveguide (TL deflective area).

The TL deflecting areas are preferably provided so as to reflect or redirect light that is propagated in the waveguide unit towards a desired area or direction, in particular towards a waveguide exit area or region 47.

In an embodiment, IL deflective areas of said group of IL deflective areas 31-34 have an orientation and/or geometrical form that is suitable to direct, and possibly focus or defocus, said incoming light so as to enable light transport towards one or more TL deflective areas 36, 37, preferably via total internal reflection within said waveguide unit and/or medium.

The waveguide unit 71 preferably comprises external side walls 26-29 that are oriented in such a manner so as to favor the reflection of light that has entered the waveguide unit via an IL deflecting area 31-34 and to direct the propagation of that light towards the waveguide exit or towards TL deflecting areas 36, 37.

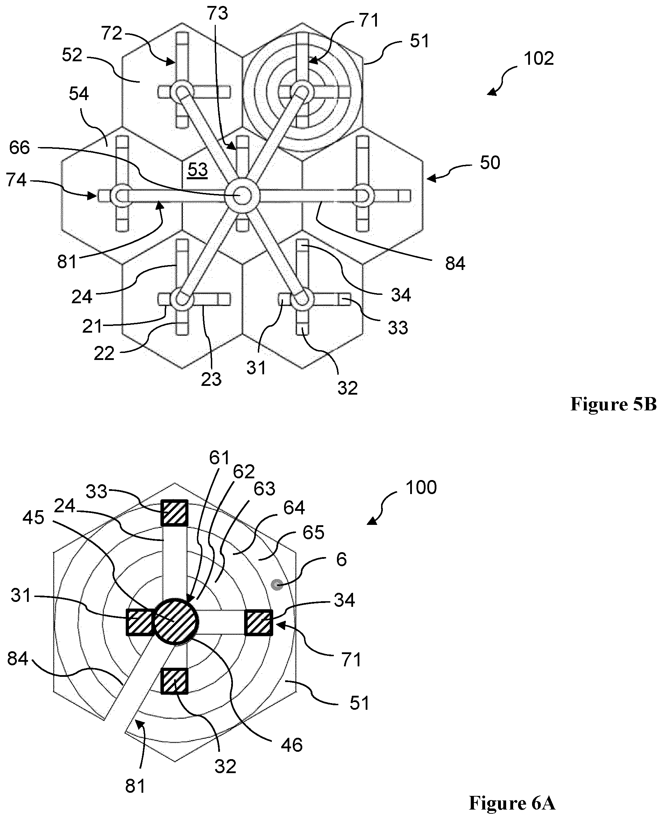

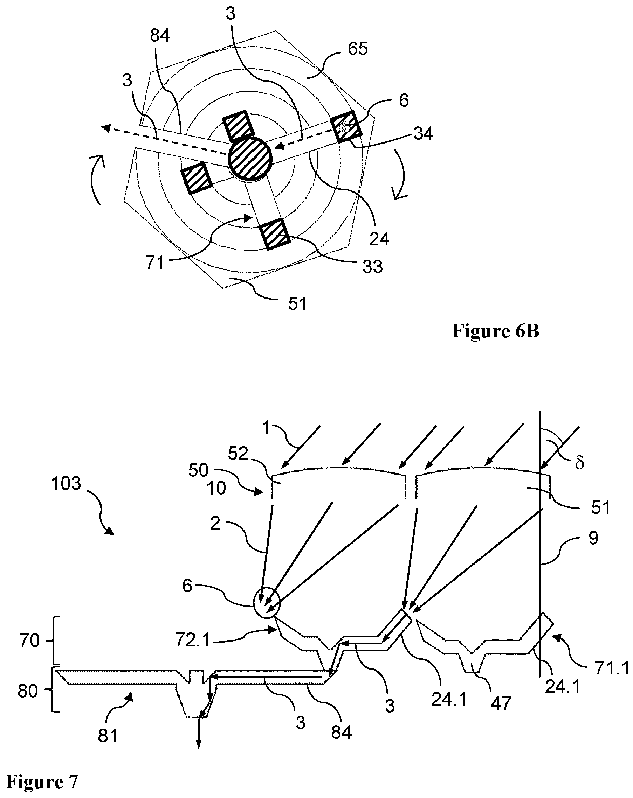

Preferably, the waveguide unit 71 comprises a junction region 46. The junction region is a region of the waveguide unit towards which the propagating light 3 provided by the different IL deflective areas 31-34 is propagated. In some way, the junction region can be seen a central region, even though the geometric position of the junction region may but need not be central with respect to the overall waveguide unit, as discussed with respect to Figs 6A and 6B. The TL deflecting areas 36, 37 mentioned above are preferably provided at or in the junction region 46, or in the proximity of the junction region.

The IL deflective areas 31-34 may also be referred to as *distal* IL deflective areas, as they are provided distal with respect to the junction region 46 and they have the purpose of directing light towards the junction region. For receiving and redirecting focused light that arrives directly from the focusing entity at said junction region 46, the waveguide unit may comprise one or more *proximal* IL deflective areas, and/or a transfer module 45, wherein said proximal IL deflective areas are preferably provided in the junction region or in its proximity, as described elsewhere in this specification.

In an embodiment, said one or more TL deflective area 36, 37 of a waveguide unit 71, 72, ... is provided in proximity of a central region or of the junction region of said waveguide unit 71. This preferably also applies to a transfer module 45, if present.

It is noted that the waveguide exit 47 may but need not imply a transfer of one light propagating medium to another medium. The waveguide exit preferably defines an area or region where light that was gathered at the junction region 46 and received via different IL deflective areas 31-37 of a given waveguide unit 71 is transferred for further use, concentration or transfer. If a transfer module and/or a proximal IL deflective area is present, the former preferably also directs light towards said waveguide exit.

In some embodiments, light may be transported from the waveguide exit towards a PV panel, transformed into another form of energy or transferred for other use, for example via an optical fiber or other light conductive connection. In some embodiments, as described further below, the exit (or transfer) light beam 5 may be joined with other light beams, preferably leading to more concentrated and/or intense light. The term "waveguide exit" therefore depends on the consideration of the waveguide unity 71 as being a particular entity, such that, at the waveguide exit, light leaves that entity for being transferred to another structural entity, which may in some embodiments be made of the same material and/or in one piece with said waveguide unit 71. In an embodiment, light is transferred via a waveguide exit towards another medium, for example from a waveguide material to air. In another embodiment, the waveguide exit does not imply a change of medium. In some embodiments, the waveguide exit is an area or region where a light beam leaves a waveguide layer and/or waveguide subassembly and is transferred to another waveguide layer and/or another waveguide subassembly, or to a transport cable or medium.

Preferably, the waveguide unit comprises a plurality of IL deflective areas 31-34, for example 2-100, preferably 2-50, more preferably 3-20 and most preferably 4-10, preferably separate, (distal) incoming light deflective areas 31-34. The IL deflective areas are provided so as to receive focused light depending on a direction or an angle α, β, γ of the incoming light with respect to axis 9, which is preferably normal to the plane 8. Plane 8 is preferably the plane in which the focusing device 50 extends and/or is aligned, or is parallel the plane in which the focusing device 50 extends. Plane 8 preferably defines the overall orientation of the assembly 100 and the overall surface on which external light 1 impinges.

As shown in Figs 1A-2B, the angle α or β of the external light 1 with respect to the light focusing entity 51 defines the position of the focus region 6. With the focusing entity 51 remaining at a fixed position, the angle of the external light 1 impinging on the focusing entity 51 determines where the focused light 2 will be directed to, and where will be the point or region 6 of maximum light intensity or maximum focus.

In order to be able to capture the light at the focal point or region 6, independently of the incident light angle, the waveguide unit 71 preferably comprises a group of IL deflective areas 31-34, wherein different IL deflective areas are provided at different and separate positions with respect to said waveguide unit 71, and wherein said different separate positions are selected such that a given separate IL deflective area 31 receives focused light 2 obtained from light 1 impinging on said light focusing entity 51 at a particular angle α, direction or range of angle and/or direction, and preferably wherein another separate IL deflective area 32 receives focused light 2 obtained from light 1 impinging on said light focusing entity at a another particular angle β , direction or range of angles and/or directions. For the purpose of the present specification, the expressions "different angle", "another angle" or "other angle range" is also an angle of incident light that has the same absolute value with respect to axis 9 as light having the same incident angle but impinging from another direction. For example, in Figs 1B and 1C, angles α and β are considered different incident light angles, even if their absolute amount may be identical. As can be seen in this case, light 1 is emitted from light sources having different orientations with respect to assembly 100, so as to provide focus regions 6 at different positions in the assembly 100. One may thus also refer to light impinging from a different direction instead of light impinging at another incident angle.

Put in other words, said group of IL deflective areas 31-34 comprises a first, second, third and up to n^{th} individual IL deflective areas 31-34 provided at a first, second, third and up to n^{th} different individual positions with respect to said waveguide unit 71, said individual positions being selected such that light impinging on said light focusing device 50, 60 at a first, second, and up to nth different angle (α, β, γ, ...), direction, or range of angle or directions, respectively, is focused towards said first, second and up to n^{th} different individual IL deflective area, respectively, or directly to a junction region 46.

In some embodiments, there are first, second, third and up to n^{th} groups of IL deflective areas 31-34 provided at different positions with respect to said waveguide unit 71, said positions being selected such that light impinging on said light focusing device 50, 60 at a first, second, and up to nth different angle (α, β, γ, ...), direction, angle ranges or range of directions, is focused towards said first, second and up to n^{th} different group of IL deflective area, respectively, or directly to a junction region 46.

As can be seen from Figures 1B and 1C and as will be discussed again with respect to Figs 6A and 6B, the different positions of the IL deflective areas 31, 32, etc are selected such that light impinging on said light focusing device 50, 60 at different incident angles (α, β, ...), from different directions or from different ranges of angles or directions, respectively, is focused towards at least one of said IL deflective areas 31-34 depending on the angle (α, β, γ, δ, ...), preferably to said one (preferably only one) of said IL deflective areas (31-34), depending on the incident angle.

As will be understood, there is one (a single) focusing entity 51 provided for a group of IL deflective areas 31-34, said group thus containing a plurality of IL deflective areas. The focusing entity preferably provides focused light to only one IL deflective element at a time. In an embodiment, said group of IL deflective areas 31-37 comprises said one IL deflective area 31 and remaining IL deflective areas 32-37, wherein said remaining IL deflective areas are provided not to receive any focused light while said only one IL deflective area receives said focused light.

In a preferred embodiment, at one given moment in time, a waveguide unit is provided to receive focused light provided by one focusing unit.

Preferably, the different IL deflective areas 31-34 are provided at different, spaced apart and/or isolated positions with respect to or in said waveguide unit 71.

Preferably, said positions are selected so as to exclude the interruption of a light path that directly leads from one of said separate IL deflective areas 31 to one of said TL deflecting areas 36, 37, preferably by internal reflection, such as TIF. In other words, the different IL deflective areas 31-34 of a given waveguide unit 71 are positioned so as not to interrupt or block the path of light that directly leads from another IL deflective area to the junction region and/or to one of the TL deflecting areas 36. Preferably, said positions define separate and non-overlapping light paths within the waveguide unit, wherein each of said separate, non-overlapping light paths leads from one of said separate IL deflective areas to one of said TL deflecting areas.

Preferably, the waveguide unit 71 comprises at least one TL deflecting area for each IL deflective area. In some embodiments, a TL deflective area is used for several different IL areas.

In an embodiment, the different (distal) IL deflective areas 31-34 of said group of IL deflective areas are provided at varying, preferably different distances from one or more TL deflecting area 36, 37. As will be described elsewhere in more detail, said IL and TL deflective areas define light channels 21-24, which may have different lengths, widths, profiles and shapes.

As can be seen in Figs 1A and 2A, the assembly of the invention also takes into account the particular situation where the focused light 2 arrives directly at the junction region 46 and/or close to the waveguide exit 47. In these figures, this happens when the angle of incident light 1 is 0° or close to 0°, preferably between 0 and ±15°, that is the light impinges in a direction that is approximately normal to the plane 8. Depending on the construction of the assembly 100, 101, this may also happen at another given angle or angle range. In this situation, a distal IL light deflective area, as described above and provided to redirect the light towards the junction region does generally not receive light. In this case, the focused light 2 preferably enters the waveguide unit directly, possibly without need of deflection. Similarly, the TL deflective area 36, 37 may not operate to transfer the light towards the waveguide exit 47.

In an embodiment, the waveguide unit comprises a junction region 46, which may comprise light deflecting areas that are suitable to directly guide incoming light towards a waveguide exit.

In an embodiment, the waveguide unit further comprises a light transfer module 45 (herein after: "transfer module"), provided to receive focused light 2 and to direct said focused light out of said waveguide unit 71 and/or towards and/or through a waveguide exit 47. The transfer module may comprise a refractive area that can be flat or curved, suitable to transfer the focused light entering the waveguide unit at the junction region towards the waveguide exit.

As can be seen in Figs 1A-2B, concentrated light 5 exits the waveguide unit at a side that is opposite to the side where the focused light enters the waveguide unit. In an embodiment, the waveguide unit 71 comprises two opposed, first and second main sides 11, 12, wherein said focused light 2 enters said waveguide unit through said first side 11 and wherein said one or more transferring light deflective area 31-37 are provided to provide a transfer or exit light beam 5 leaving said waveguide unit at said opposed second side 12.

In Figs 1A-2B, first and second sides 11, 12, of the waveguide unit 71 are shown to extend in parallel, which may but need not necessarily be the case.

In an embodiment, the exit light beam 5 has a direction that is preferably normal to the overall plane 8 of the assembly 100, and/or which is preferably parallel to light 1 impinging on the assembly 100 and/or on the focusing device 50, 60 with an 0° incident angle, as shown in Figs 1A and 2A, for example. For avoiding misunderstandings, it is noted that, in accordance with this embodiment, the direction of individual photons need not be normal to the overall plane, but the overall direction of photons, for example as determined by the orientation of a light channel comprising the exit light beam 5, may be substantially normal (±10°) to the overall plane 8 of the assembly 100. Of course, the invention envisages other angles and/or directions of a light beam and/or light channel for guiding light out of the assembly.

**Figure 3** shows an assembly 102 comprising a light focusing device 50 comprising a plurality of focusing entities 51-56 and a waveguide subassembly 70 comprising a plurality of waveguide units 71-76. Preferably, said focusing device comprises a plurality of focusing entities 51-56, so that said waveguide subassembly 70 is arranged to provide a plurality of transfer light beams 5 for transferring light received via separate focusing entities propagated in separate waveguide units 71-76. The embodiment shown comprises a further, and/or second waveguide subassembly 80.

In an embodiment, each waveguide unit 71-76 comprises one or more waveguide exit 47 providing a light beam of transfer light 5 (or exit light), so that said waveguide subassembly 70 is arranged to provide a plurality of transfer light beams 5. Preferably, each waveguide unit provides at least one transfer light beam 5, the number of exit light beams being thus preferably equal or potentially larger than the number of waveguide units.

As can be seen in Fig. 3, the assembly 102 may comprise more than one waveguide subassemblies. In an embodiment, said waveguide subassembly 70 is a first waveguide subassembly, and said assembly 102 comprises a second waveguide subassembly 80. Preferably, said second waveguide subassembly is provided to receive two or more transfer light beams 5 provided by said first waveguide subassembly 70.

In an embodiment, the first waveguide subassembly 70 comprises a plurality of waveguide units 71-76, each waveguide unit providing one or more transfer light beams 5, 5.1, 5.2, ... , wherein said second waveguide subassembly 80 is provided to receive two or more transfer light beams provided by two or more waveguide units 71-76 of said first waveguide subassembly 70.

In the embodiment shown, the second waveguide subassembly 80 is preferably provided below the first waveguide subassembly 70, more preferably vertically below. The second waveguide subassembly is preferably positioned and/or oriented in a plane that is parallel to the plane 8, defining the overall orientation of the assembly 102.

The second waveguide subassembly 80 may have a conceptually similar and/or identical construction plan as the first subassembly 70. In an embodiment, the second waveguide subassembly 80 comprises one or possibly more waveguide units 81, 82, ... , each unit comprising a plurality of IL deflective areas 83, provided to propagate light 3 inside the corresponding waveguide unit. The IL deflective areas 83 may receive focused light provided by a focusing entity 51, and/or, as shown in Fig. 3, transfer light 5 transferred from the first waveguide subassembly 70. The waveguide unit 81 of the second subassembly 80 preferably also comprises a junction region 86, where TL deflective areas are provided. The TL deflective areas are provided to orient the propagated light 3 coming from the IL deflective areas 83 towards the waveguide exit 87 of the waveguide unit 81. At the waveguide exit 87, a transfer light beam 15 is provided, which exits the waveguide unit 81 of the second subassembly 80 for further use, concentration or transfer.

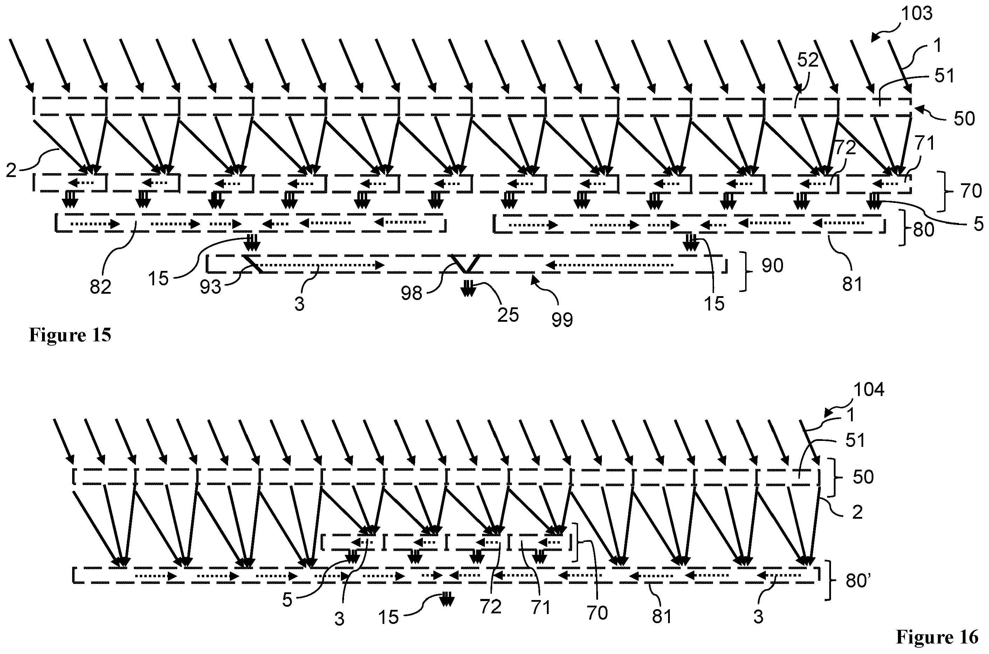

In a preferred embodiment, the exit light 15 preferably exits the waveguide unit 81 on a second side 14, which is preferably substantially opposed to the side 13 of the waveguide unit, where the incoming light is received by the IL deflective areas 83. It is noted that first and second sides 13, 14, of the waveguide unit 81 are shown to extend in parallel, which may but need not be necessarily the case. The second subassembly 80 may comprise one or a plurality of waveguide units 81, 82, as shown in Fig. 15.

It is noted that the incoming light of a waveguide entity 81 of the second waveguide subassembly or layer 80 corresponds to an transfer light or light beam 5 of a waveguide entity 71 of the first waveguide subassembly or layer 70.

Figs 3, 15 and 16 illustrate embodiments, wherein the light collecting assembly 102, 103, 104 comprises a plurality of waveguide subassemblies arranged in layers 70, 80, 80', 90, a first layer receiving focused light 2 and one or more subsequent layers 80, 80', 90 successively, and preferably sequentially, arranged in such a manner that one of said subsequent layers 80, 80', 90 receives a plurality of transfer light beams 5, 15, 25 provided by waveguide units 71-76; 81, 82 of at least one of the respective preceding waveguide layers 70, 80, 80'. In some embodiments, said subsequent layer 80' optionally also receives focused light 2 provided by said light focusing device 50 (Fig. 16).

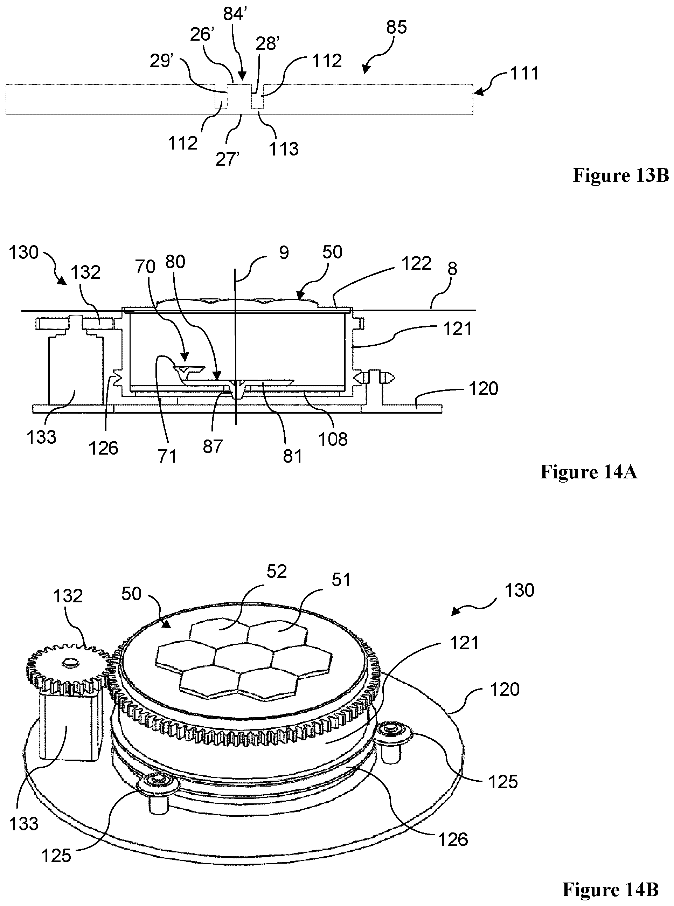

**Figure 4A** shows a waveguide unit 71 according to an embodiment. The waveguide unit may be used, for example, in an assembly 100-104 as shown in any one of Figs 1A through 3, or any one of Figs 14A through 16. In particular, the waveguide unit 71 is preferably one of several units of a first waveguide subassembly or layer 70.

In a preferred embodiment, the waveguide unit 71 comprises a plurality of light propagating arms or light channels 21-24. Preferably, each arm comprises an IL deflective area.

In a preferred embodiment of the light collecting assembly, said light channels are provided in the form of arms consisting essentially of a waveguide medium. In a preferred embodiment, the arms 21-24 are joined at the junction region 46.

Preferably, each IL deflective area is provided to receive light and reflect the light so as to favor the propagation of the light inside the arm and/or light channel, and preferably towards a junction region 46.

In a preferred embodiment, the waveguide unit 71 comprises a plurality of light channels 21-24, each light channel extending from an IL deflective area (preferably only one IL area) to a TL deflective area, wherein said light channels extend radially from said junction region 46.

Preferably, a waveguide unity 71 of a first waveguide subassembly 70 comprises light channels 21-24 having different lengths. Preferably, the light channels extend in different directions.

Preferably, said light-channels 21-24 are non-overlapping.

One, several or all light channels 21-24 are preferably longitudinal and define a longitudinal channel through which the light is propagated from the distal IL reflective area towards the junction region. The channels preferably have a rod-like and/or bar like aspect. While Fig. 4A shows light channels having a rectangular cross section, the invention encompasses longitudinal light channels having any cross section such as circular, elliptical and/or polygonal cross sections, for example. Furthermore, the light channels may have one or more bends, curves, S-shapes, and the like.

As visible from Fig. 4A, each light channel is defined and/or delimited by way of walls which preferably reflect light. In the embodiment shown, each light channel generally comprises two lateral walls 28, 29. The light channels preferably also comprise top and bottom walls 26, 27. Note the very short light channel 21, which is so short that a bottom wall is nearly absent and may actually be absent. In case separate walls are absent, for example in case of a light channel having a circular or elliptical cross-section, reference to "walls" may be considered as reference to "sides" or "arcs" delimiting the dimensions of light channel laterally along their longitudinal extension.

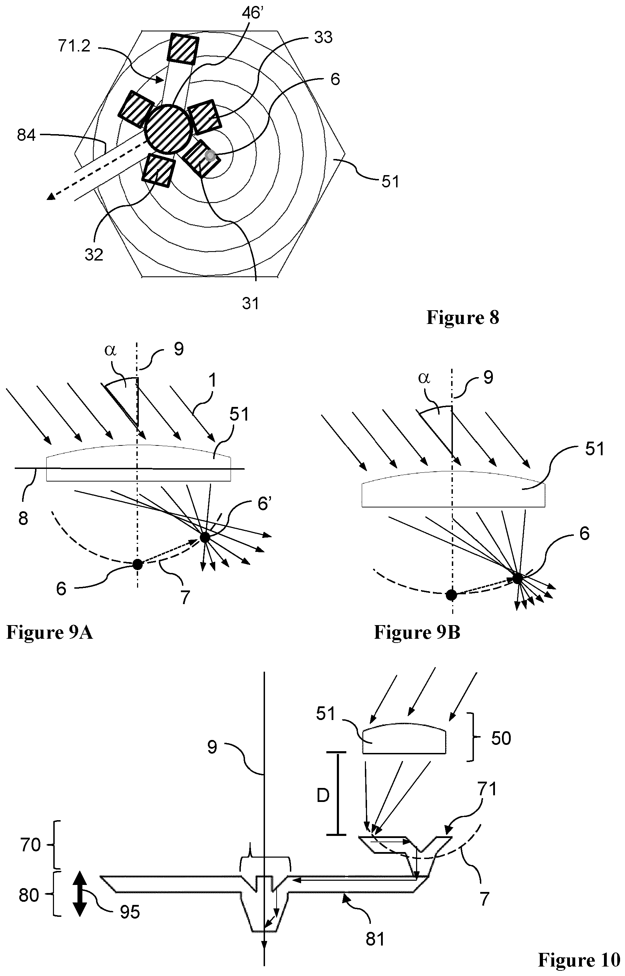

The lateral walls 28, 29 as shown in Figs 4A and 4B preferably extend in a substantially vertical direction (corresponding to axis 9 in Fig. 9A), whereas the top and bottom lateral walls of a light channel preferably extend horizontally, that is, in parallel to plane 8 defined previously. In Fig. 4A, reference numerals 28 and 29 concerning the lateral walls are shown with respect to two different light channels, for reasons of perspective, it being understood from the figure that each channel 21-24 has two lateral walls.

The two lateral walls of a light channel may extend in parallel. In some embodiments, the two lateral walls 28, 29 of a given light channel slightly converge so that they are closer towards the junction region and more spaced apart at the IL deflective area. This may, independently, also apply for top and bottom walls 26 and 27. In an embodiment, said lateral walls (or sides) extend substantially in parallel or form an angle of not more than 20°, preferably not more than 15° one lateral wall or side of the light channel with respect to the other lateral wall or side of the same light channel along a direction from the IL deflective area towards the TL deflective area.

In a preferred embodiment, each light channel or arm 21-24 has a free extremity, wherein an IL deflective area is provided at and/or by the free extremity. In an embodiment, the number of arms of the waveguide unit 71 corresponds to the numbers of (distal) IL deflective areas 31-34. The numbers of 2-100 distal IL deflective areas, and preferred embodiments, as disclosed above, thus also apply to the numbers of light channels and/or arms of a waveguide unit in accordance with an embodiment.

In a preferred embodiment, the different arms (or light channels) of the waveguide unit have different lengths, for example as seen in Fig. 4A. This applies in principle to the first waveguide subassembly, which receives focused lights provided by the focusing entities. As will be described elsewhere in more detail, the different lengths will enable the capturing of a focal region 6 produced by the focusing entity depending on a direction or angle (e.g. α, β, γ) of incident light. It is not necessary that all arms have different lengths, and possibly the assembly of the invention may also be constructed so as to include arms having similar or identical lengths, as illustrated in Fig. 8.

The distal IL deflective areas preferably have a limited dimension and/or extension within a waveguide unit along a horizontal axis. Each IL deflective area is preferably provided to receive and deflect a spatially limited, single focal region 6 produced by a focusing entity 51. The present invention preferably differs from US 9,337,373 in that the light deflective areas do not extend over a substantial part or even over the entire length or breadth of the waveguide. Preferably, the geometrical shape of the IL deflective area is not substantially longitudinal and/or is not extending along a substantial part of a circle (e.g. along half or a quarter of a circle), but is compact. In an embodiment, the lateral extension (breadth) of an IL deflective area is ≤30 cm, preferably ≤20 cm, more preferably ≤15 cm, even more preferably ≤10 cm and most preferably ≤5 cm. This lateral extension corresponds to the distance that separates the two lateral walls 28, 29 at the level of the IL deflective area.

As can be seen in Figs 4B and 14B, the focusing entity 51 preferably comprises a lens or a mirror having at least a part that exhibits axial symmetry, such as, for example, a spherical lens or mirror. The lens or mirror may also be aspherical, but preferably comprises a part that exhibits said axial symmetry. The part comprising the axial symmetry is preferably a central part, providing said focused light.

In some embodiments, the lens does not necessarily exhibit a circular outline and therefore may not exhibit said axial symmetry, or may not exhibit axial symmetry at the outline of the lens. For example, in the embodiment shown on Fig. 4B, the lens has a polygonal outline, which here is shown to be a hexagonal outline. The focusing of the invention may thus comprise a lens and/or mirror that exhibits discrete rotational symmetry. Preferably, said discrete rotational symmetry is a more than 2-fold rotational symmetry, for example a discrete rotational symmetry that is 3-fold or more, for example 3 to 20-fold, preferably 4 to 10-fold.

The lens or mirror preferably exhibits a focal point or a single, compact, for example circular, and/or non-longitudinal focal region. Preferably, the focusing entity lacks a cylindrical lens or a lens generating exclusively or mainly longitudinal and/or annular focal regions. Preferably, the focusing entity lacks a lens selected due to its ability of generating longitudinal and/or annular focal regions. The compact distal IL deflective areas are preferably suitable to receive the focused light provided by the focusing entity.

The TL deflective areas are provided in the junction region 46, preferably inside the waveguide unit 71, and are not visible in Fig. 4A. The TL deflective areas need not be separated but may be joined and may also be provided in the form of a continuous area. For example, instead of a plurality of separate TL deflective areas, a continuous, curved, for example conical, TL deflective area may be provided to deflect propagated light deflected by two or more distal IL deflective areas and/or to deflect light propagated through two or more different light channels.

In the embodiment shown, the junction region is substantially cylindrical. The bottom of the junction region is thus substantially circular in the embodiment shown. The bottom forms a waveguide exit 47, which is an area through which the light coming from the different IL (and through the corresponding arms) deflective areas is guided. It is noted that, at a given moment in time, light is generally received mainly or only from one of said IL deflective areas 31-34 of a given unit 71, since a given focusing entity 51 only provides light towards one of said IL deflective areas of an individual unit 71. Light may also be received from none of the distal IL deflective areas and may be focused directly towards the joining region 46, depending on the incident light angle, for example via the transfer module 45.

Below the junction region 46, a transfer structure, which may also be considered as the waveguide exit 47, is provided. In the embodiment shown in Fig. 4A, the transfer structure has a substantially conical form, but may have any other suitable form, for example a cylindrical form. As will be discussed with respect to Fig. 4B, the transfer structure is suitable to direct the light towards a waveguide unit 81 of a second subassembly.

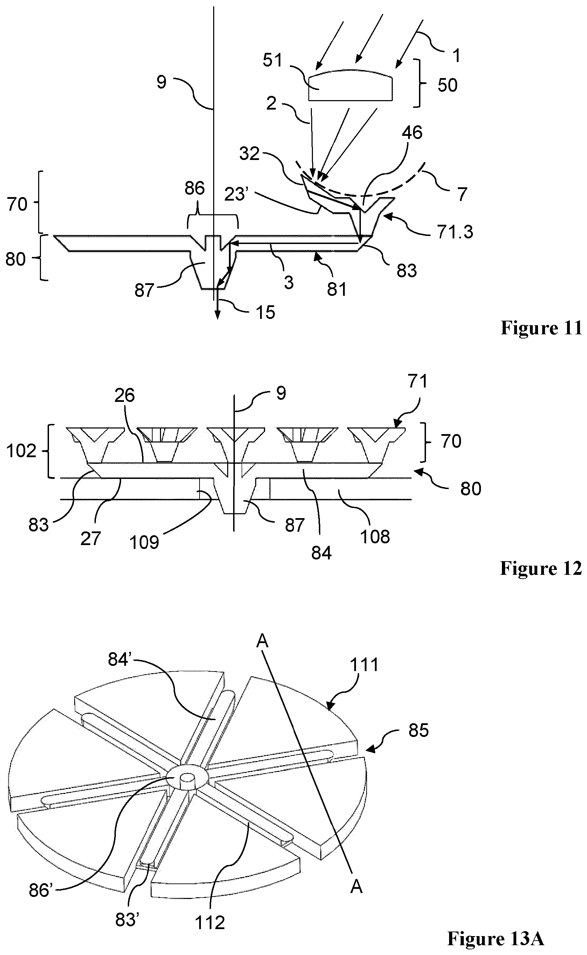

While the embodiment in Fig. 4A uses arms 21-24 of a waveguide material for guiding light from the IL deflective areas 31-34 to the TL deflective areas and/or towards the waveguide exit 47, it is also possible to integrate the IL deflective areas in a continuous material, such as a disk-shaped waveguide, which lacks free-standing arms or arms having free standing extremity (Fig. 13A and 13B). The arms 21-24 are just one option of propagating light within a waveguide. US 2010/0278480 and US 9,33,373 disclose disk-shaped or generally continuously, flat, board-like waveguides. While the use of arms as disclosed may provide some advantage in terms of material use, many embodiments and advantages of the present invention may be obtained by using a continuous waveguide unit in which different lights channels are provided by providing light deflective areas at appropriate positions in the waveguide medium or material.

From the above one may understand that instead of mentioning different light channel's or arm's lengths, one may also say that the distance between an IL deflective area and a corresponding TL deflective area may be different within the light channels of a waveguide unit 71.

One may therefore say, more generally, that the invention preferably provides a waveguide unit 71 comprising a plurality of light channels 21-24, wherein said light channels may be defined by a distance between an IL deflective at a first extremity of the light channel and a TL deflective area, the TL deflective area being provided to transfer light towards a waveguide exit. In the embodiment shown, the TL deflective areas are provided in the junction region 46. In an embodiment, there is one TL deflective area for each IL deflective area and/or for each light channel 21-24.

Preferably, said light channels 21-24 are separate and distinguishable from other areas of a waveguide unit as they define a path of light within the waveguide unit, wherein, in other parts of the continuous waveguide material of the waveguide unit, there may be no usable light be propagated or the light has significant lower intensity and/or may not be efficiently exploited outside said light channels within a possibly continuous waveguide material.

It is noted here that the different components of the waveguide units and/or waveguide subassemblies may be realized by connecting separate components, for example by rigidly fixing the components together by gluing or welding, for example ultrasonic welding, or, alternatively, by providing the waveguide unit and/or subassembly in one piece, for example by 3D printing techniques, molding techniques and/or by machining the units and/or assembly starting from a continuous material. In some embodiments, one, two or more waveguide subassemblies 70, 80, 90 may be made in one piece, for example by machining from a continuous waveguide material.

**Figure 4B** shows the plurality of focusing entities and waveguide units of an assembly 102 according to an embodiment of the invention. The focusing device 50 with entities 51-54 in relation to the corresponding waveguide subassembly 70 with units 71-74 are visible. Each entity preferably comprising a lens comprising a central part with axial symmetry. It is noted that only some focusing entities and waveguide units are shown with individual reference numbers. Fig 4B shows seven (7) focusing entities of focusing device 50 and seven (7) waveguide units of a first waveguide subassembly 70. An exemplary support structure for carrying the focusing device and waveguide subassembly is described in Figs 14A and 14B.

The operation and function of the assembly in Fig. 4B has been described with respect to Fig. 3. Fig. 4B shows in particular that the second waveguide subassembly 80 comprises a plurality of arms and/or light channels 84, and has a similar overall star-like construction as the first waveguide subassembly 70. Fig. 4B also exemplifies the concept of vertically structured and/or layered waveguide subassemblies, with the second subassembly 80 being provided below the first subassembly 70 and provided to receive the light collected by the first subassembly.

In particular, the second subassembly 80 comprises a waveguide unit 81. The waveguide unit 81 preferably comprises a plurality of light channels 84, which here are realized in the form of arms. Only one reference numeral 84 is used, although the waveguide unit 81 of the second waveguide subassembly 80 of the embodiment shown has six (6) arms. At the distal, free extremity of each of the light channels 84, an IL deflective area 83 is provided. An individual IL deflective area 83 is provided to receive exit light 5 from the waveguide exit 47 of an individual waveguide unit of the first waveguide subassembly 70. In this embodiment, all arms and/or light channels 84 of the waveguide unit 81 have identical lengths. As mentioned, light channels having different lengths are also encompassed by the invention.

The light channels 84 of the waveguide unit 81 converge towards and/or are joined at a junction region 86. At the junction region, one or more TL deflective areas are provided for deflecting the light reflected at the IL deflective areas 83 and propagated within the channels 84. The TL deflective area or areas 88 (Fig. 5A) deflect the propagated light towards a waveguide exit 87 of the waveguide unit 81.

The waveguide unit 81 of the second waveguide subassembly may comprise a plurality of light channels 84. In particular, a plurality of waveguide units of the first subassembly 71 are joined as a group by way of the waveguide unit 81 of the second subassembly 80, such that the number of light channels 84 corresponds to the number of waveguide units 71 the light of which is collected by the waveguide unit 81.

One my say that there is a hierarchical and/or pyramidal organization of waveguide subassembly layers.

In an embodiment, the assembly 102 comprises a plurality of waveguide subassemblies provided in layers 70, 80, a first layer 70 receiving focused light 2 and one or more subsequent layers 80 successively, and preferably sequentially, arranged in such a manner that one of said subsequent layers 80 receives a plurality of transfer light beams 5, 15 provided by waveguide units 71-74 of at least one of the respective preceding waveguide layers 70. Figure 15 and 16, described further below, provide additional embodiments for illustrating the layered and/or pyramidal concept. Optionally, said subsequent layer 80' also receives focused light 2 provided by said light focusing device (Fig. 16).

**Figure 5A** illustrates the light collection and the direction of the flow of light through the device of an embodiment. In Fig. 5A, only a single waveguide unit 71 is shown for the first waveguide subassembly 70, for reasons of clarity. External light 1 impinges at a given angle or direction on the focusing entity 51, which provides focused light 2. The waveguide unit 71 of the first waveguide subassembly 70 comprises a plurality of IL deflective areas, one of which (numeral 31) deflects the focused light 2 and provides light 3 propagated by internal reflection, e.g. by TIR, within the waveguide unit 71. A TL deflective area 36, provided preferably at a junction or center region, deviates the flow of light towards an IL deflective area 83 of a waveguide unit 81 of a second waveguide subassembly 80. The IL deflective area 83 is provided to deflect the light and to direct the light flow into a light channel 84 of the unit 81 and towards an TL deflective area 88 of the later, which again redirects the light flow, for example towards a waveguide exit or transfer structure 87 of the unit 81. The light exiting the waveguide unit 81 is available for further use and/or transport.

Since the light captured by a plurality of waveguide units 71-74 of the first subassembly 70 is guided towards a waveguide exit 87 of a single waveguide unit 81 of a second subassembly 80 (Fig. 4B), the light at exit 87 is concentrated light. The intensity of the light at exit 87 compared to the intensity at the exit 47, is increased by a factor that is related to the number of waveguide units 71-74 which converge their light towards waveguide unit 81. As further layers are added to the assembly, the light intensity is further increased.

**Figure 5B** is a top-down view of the device shown in Fig. 4B and partially in Fig. 5A. As already seen from Fig. 4B, the light focusing entities 51-54 have a hexagonal outline. In a more general embodiment, the focusing entities have a curved, elliptical, circular and/or a polygonal outline, preferably a quadratic, pentagonal and most preferably said hexagonal outline. The light focusing entities have preferably an outline that allows joining the focusing entities of a focusing device 50 so as to provide a focusing device that is in one piece and/or comprising light focusing entities that are rigidly connected within said light focusing device.

Fig. 5B shows a plurality of concentric rings with respect to one focusing entity 51 and/or waveguide unit 71. **Figures 6A** and **6B** show these rings in more detail. From the perspective of the light impinging on the focusing entity 51 at a particular incident light angle, one may draw concentric circles around a center, which center coincides with a center of the focusing entity in the top-down view. The concentric circles are drawn to define a plurality of preferably concentric zones 61-65, in which the focus region 6 (see also Fig. 1B) will fall in dependency of the incident light angle and/or direction. These zones may thus be considered as focal region zones.

If the incident light angle is 0° (or 90° with respect to the overall plane 8 of the light focusing device), the focusing region 6 will be in the central concentric region 61. On the other hand, if the external light 1 impinges at a given angle α, which is different from 0°, the focusing region 6 will be deviated from the center towards an outer zone defined by said concentric rings, whereby the larger the incident light angle (α, β), the larger the deviation of the focal region towards the outer zones. It is noted here that the incident light angle may also affect the height of the focal region 6 on a vertical axis, as discussed in more detail with respect to Figs 9A and 9B. At this stage, it is sufficient to understand that the different zones 61-65 defined by said concentric rings need not necessarily be in the same vertical plane.

In Figure 6A, a focal region 6 is shown, which here lies in the outermost concentric zone 65. The focal region 6 comprises the focused light 2 provided by the light focusing entity 51 at a given incident light angle. As can be seen in Fig. 6A, the distal light deflective areas 31-34 are separate, spaced apart and do not cover an entire concentric zone. The IL deflective areas have a generally confined, for example quadratic outline and span only over a comparatively minor area compared to the entire concentric zone in which they are located. As a consequence of the shape of the IL deflective areas, none of the latter is provided to capture the focused light at focus region 6. In a preferred embodiment, the embodiment shown provides a rotation mechanism in order to efficiently capture the light at focus region 6.

In an embodiment, the light collecting assembly 100-104 comprises one or more components that are provided rotatably. Preferably, one or more components are rotatable with respect an axis 9 (Figs 11, 12 and 14A). Axis 9 is preferably substantially normal to the overall light collecting assembly 100 and/or to first and second opposed sides of said waveguide subassembly 70.

In an embodiment, one or both selected from said waveguide subassembly and said focusing device is provided rotational in said light collecting assembly. In an embodiment, said focusing device and said waveguide subassembly are both provided rotational, preferably co-rotationally, with respect to said axis 9.

The rotation as defined herein is provided for allowing solar tracking. For the purpose of the present invention, the term "solar tracking" has its generally understood meaning, namely that the device or only parts thereof conduct movements as described herein for the purpose of maximizing light collection while the incident light angle changes over time, for example over a day or over a longer period.

In an embodiment, axis 9 is normal to a plane 8 with respect to which the focusing device and/or the focusing entities are aligned.

In an embodiment, rotation of the focusing device and/or the focusing entity is an in-plane rotation. Preferably, the focusing device is provided to conduct exclusively in-plane rotation.

In an embodiment, the rotation is provided to be conducted in-plane and within the device external casing of the assembly. In another embodiment, the housing may comprise a circular or annular part for holding the focusing device, with the focusing device being rotated together with the circular or annular part.

In an embodiment, said rotatable components comprise one or more selected from:
- an arrangement comprising one or more waveguide subassembly 70, 80, 90, and,
- an arrangement comprising the light focusing device 50, 60 and one or more waveguide subassembly 70, 80, 90.

As shown by way of the curved arrows in Fig. 6B, rotational displacement of the waveguide unit 71 results in a displacement of the IL deflective areas 31-34. In particular, the IL deflective areas are provided to move on a respective concentric zone 62-65, that is, to move on a circular path. As shown, IL deflective area 34, configured to move in zone 65, has been displaced by way of a rotation and/or circular translational movement to coincide with the focal region 6. As shown in Fig. 6B, the focused light will be effectively collected by an IL deflective area, for example as shown in Fig. 5A. The dashed arrows in Fig. 6B show the light propagated in the light channel 24 of the waveguide unit 71 and further through the light channel 84 of waveguide unit 81 of the second subassembly 80.

A shown in Figs 6A and 6B, the waveguide unit 71 may be rotated alone or together with focusing entity 51 around an axis that extends in the center of the concentric zones 61-65, in a direction that is normal to the plane in which the figures are shown. The axis of rotation corresponds to or is preferably parallel to axis 9 as shown in Fig. 9A. As has been shown in Figs 3, 4B and 5B, the waveguide unit 71 may be connected with adjacent waveguide units 72-74 and preferably with a waveguide unit 81 of a second waveguide subassembly 80.

Accordingly, the rotation axis may lie in the center 66 (Fig. 5B) of a central light focusing entity 53, which may result in the rotation of the focusing entities, too, and/or which may also result in a displacement of a waveguide unit with respect to a particular focusing entity.

For example, referring to the assembly 102 as shown in Fig. 5B, the waveguide subassembly 70 may be rotated with respect to center point 66. Assuming that subassemblies 70 and 80 rotate without the focusing device, an IL deflective area of waveguide unit 71 may be displaced and positioned to capture focused light provided by another focusing entity, i.e. focusing entity 52, instead of focusing entity 51, as may be suggested by the arrangement as shown in Fig. 5B. This is because the rotational movement as described may cause an individual waveguide unit 71 to move along a circular trajectory and need not necessarily conduct a rotational movement around its own center region.

In other words, referring to Figs 6A and 6B, Fig. 6B may reflect the result of a rotation with respect to an external axis, not shown in Figs 6A and 6B, where waveguide unit 71 has been displaced, possibly together with focusing entity 51, on a circular path until a particular IL deflective area is positioned so as to effectively harvest the focused light 2 provided by a focusing entity.

It is also noted that while Figs 6A and 6B show five (5) concentric zones, this number may be larger or lower. For example, there may be from 2 two 100 zones, preferably concentric zones. The number of zones may correspond to the number of distal IL deflective areas plus one (+1), in case incoming light is also received directly at the central zone. Preferably, for each zone other than said central zone 61, at least one distal IL light deflective area is provided. The zones 61-65 are preferably defined by the specific construction of the assembly according to an embodiment of the invention.

In an embodiment, rotation of said rotatable components is provided to allow for the tracking and/or displacement of a focus point or region 6 of said focusing entity, so as to direct said external light via a focusing entity 51 towards at least one IL deflective area 31-34 of said waveguide unit 71 or towards said transfer module 45. Preferably, rotation of said rotatable components is provided to capture said focus region 6 at different angles (α, β, ...), directions or angle ranges of said external light with respect to said assembly 100.

In an embodiment, the assembly of the invention is configured to conduct a rotational movement depending on an incident angle (α, β, ...), direction or angle range of external light 1, wherein said rotational movement is provided to be conducted until a focus region 6 of said focused light 2 is positioned with respect to an IL deflective area in such a manner that said IL deflective area effectively deflects said focused light into a medium of said waveguide unit. Preferably, said focused light 2 is positioned with respect to said one IL deflective area of said group of IL deflective elements comprised in a waveguide unit. In an embodiment, the assembly of the invention is configured to conduct said rotational movement automatically.

As one can see from the above, rotation of the rotatable components results in the focused light to be moved, and may thus be moved from one of said IL deflective areas to another one of said IL deflective areas. This is preferably exploited for solar tracking, such that, in dependence of a changing incident light angle (α), focused light can be redirected from one of said IL deflective areas to another one of said IL deflective areas.

In a preferred embodiment, said one IL deflective area receiving said focused light from said focusing entity 51 is determined by said rotational position of said waveguide subassembly 70 and further in dependence of the incident light angle α.

According to the claimed invention, single axis rotation, optionally in combination with a linear movement 95 changing a distance (D) between said waveguide subassembly and said focusing device (see Fig. 10), is provided for solar light tracking. Preferably, the linear movement extends in the same direction as, e.g. in parallel to, axis 9.

In a preferred embodiment, said single-axis rotation, optionally in combination with said linear movement, enables solar light tracking over an incident light angle range of 30° or more, wherein said 30° range encompasses light having an incident angle (α) of 15° or less with respect to axis 9. In preferred embodiments, solar tracking is enabled over an incident light angle of 40°, 50°, 60°, and 70° or more, optionally in combination with said linear movement.

In a preferred embodiment, during solar tracking, or during the rotation for solar tracking, the orientation of the focusing device with respect to horizontal does not change. This preferably also applies to the entire assembly 100. This can be also understood from the embodiment shown in Figs 14A and 14B. If the light assembly collecting assembly is positioned on a horizontal surface, it remains substantially horizontal during solar tracking. The invention encompasses that the light assembly is not positioned horizontally, for example on a pitched support structure, such as a pitched roof, on a slope or at a geographical location or during a season where incident light angles (α) are comparatively large.

In a preferred embodiment, during solar tracking, one or both selected from the light focusing device 50 and the one or more waveguide subassembly are displaced so that at least the focusing device is displaced within a single plane. Therefore, the light focusing device may be provided to rotate within a plane (e.g. plane 8 in Fig. 14A).

The one or more waveguide subassembly may also be provided to rotate in the plane in which it is provided, which is in general parallel to the plane of the focusing device.

During the rotational movement, the axial position, in particular the position along axis 9 of the focusing device remains preferably constant. Regarding the waveguide subassembly, in case it also rotates, the axial position may also remain constant, but may also be provided to change, as described with reference to Fig. 10. In this case, the waveguide subassembly may also be provided not to rotate in-plane, but to rotate in planes that are parallel. One may also envisage that the waveguide subassembly rotates in-plane and the focusing device being provided to rotate in parallel planes.

Said a rotational position of said waveguide subassembly 70 and/or said focusing device 50, is further adjustable to determine that no IL deflective area of said group of IL deflective areas receives said focused light and/or that said focused light is received by said junction region. The rotational position may be adjusted so that all light passes through the device, without any light being collected. In this case, the redirection of light through said waveguide subassembly is minimized. This feature makes it possible to provide translucency to the light collecting assembly by adjusting the rotational position and without changing the angular position of the assembly itself.

Figs 1A and 3 show embodiments in which light impinging with a 0° angle, that is, in normal direction, on the assembly 100 is directed towards a junction region 46 of a waveguide unit 71, 72, .... In these embodiments, the junction region of a waveguide unit is aligned centrally with respect to a focusing entity. In other words, light impinging in a normal direction with respect to a given focusing entity will enter the waveguide unit 71 at the junction region 46 (Figs 1A and 2A). The junction region 46 may thus lie in the prolongation of the vertical, central axis of a corresponding focusing entity 51. In this case, focused light is not (or need not be) deviated via a distal IL deflective area towards the junction region. As described elsewhere, a transfer module 45 or a suitable proximal IL deflective area may be provided to direct the light flow towards the waveguide exit without necessarily passing by said TL deflective areas.

**Figure 7** shows an embodiment of the assembly of the invention, which is configured to redirect light having a larger incident light angle. In the embodiment shown in Figs 4B through 5A, a particular waveguide unit 71 was configured to receive focused light from a focusing entity 51 placed substantially vertically above the corresponding waveguide unit. In a preferred embodiment, the waveguide units of the assembly of the invention are adapted to receive light having a large incident light angle δ, wherein δ may be larger than α, which may be the case where the sun is standing low in the mornings or evenings, for example. For example, δ may be 30° or larger, more preferably 40° or larger, and even more preferably 45° or larger.

Due to the large incident light angle, the focal region 6 generated by a given focusing entity 51 may be deviated to such an extent that the focused light cannot be collected by the corresponding waveguide unit 71.1, as shown in Fig. 7. However, waveguide units 71.1, 72.1, etc., may be provided such that a given waveguide unit 72.1 receives focused light provided by another focusing entity 51, for example a focusing entity that is further away and/or a focusing entity 51 that is a neighbor to the focusing entities 52 vertically above said waveguide unit 72.1.

In Fig. 7 and other figures, focusing entities (e.g. 51) and corresponding waveguide units (e.g. 71.1) are aligned on a vertical axis and are preferably coaxial, assuming a vertical axis of the waveguide unit 71.1 passing through the corresponding waveguide unit's exit 47. It is noted that this is not necessarily the case, as the focusing entities and waveguide units may be but need not be co-axial. The focusing entity 51 may also be shifted laterally. For example, the focusing entity may overlap not only with waveguide unit 71.1 but also with a neighboring waveguide unit 72.1. An apparent shift may also be a result of the overall form of a waveguide unit, which may be asymmetric.

The waveguide units 71.1, 72.1 of the embodiment shown are both provided with a light channel 24.1 that is particularly adapted to receive focused light 2 generated by the focusing entities when the incident light angle is particularly large. The light channel 24.1 may be adapted to receive and transfer focused light provided by any focusing entity of the assembly, not just the focusing device that is vertically above the waveguide unit containing the light channel 24.1. For example, the light channel 24.1 may have an orientation, length, geometrical form and external surfaces such that focused light can enter the light channel and be further propagated in the light channel.

In the embodiment shown, the light channel 24.1 may comprise an IL deflective area that is further away from the entry point of the focused light into the waveguide unit than in the previously shown embodiments, where the IL deflective area is generally closer to the entry point of the focused light into the waveguide medium. This is generally a design option and need not be a general rule.

**Figure 8** shows another embodiment comprising a waveguide unit 71.2, in which the junction region 46' of the waveguide unit 71.2 is not aligned centrally and/or co-axially with respect to the focusing entity 51 and the concentric zones 61-65. The waveguide unit 71.2 still comprises a plurality of distal IL deflective areas 31-34, which are positioned in different zones, such that at least one IL deflective area is provided to capture light focused towards a particular zone. In the embodiment shown in Fig. 8, a transfer module and/or proximal IL deflective areas need not be present. However, TL deflective areas at the junction region 46' are preferably present (not shown in this figure), so as to deflect the propagated light towards the waveguide exit and to the light channel 84 of the waveguide unit 81.

**Figure 9A** shows the displacement and the dispersal of the focal region as a result of an inclined incident light angle α, which is larger than 0° with respect to the normal axis 9 of the focusing entity 51, which here is a lens. Reference numeral 6 in Fig. 9A indicates the focal point in case α were 0°. With increasing deviation from 0°, the focal point is displaced along segment 7 of a circle. Considering the three dimensions, numeral 7 may be considered as defining a curved focal plane. As Fig. 9A shows, the inclination of incident light 1 brings about a change of the height of the position of the focal point, but, in addition, a dispersal or dilution of the focal point 6'. The latter problem may be addressed by providing adapted, non-spherical lens. By using an aspherical, customize lens or lens system comprising a plurality of lenses, it is possible to reduce the space covered by the focal region and to obtain a high intensity of light in a small area, similar to the situation where α is 0°. Therefore, in an embodiment, the focusing entity comprises an aspherical, preferably customized lens, having a high degree of focus even with incident light angles α > 0°. Such a lens would be suitable to provide small focusing regions. In another embodiment, the focusing entity comprises a lens-system. The aspherical, customized lens and the lens system can be used, alone or in combination, to control aberrations which might affect light capturing by the waveguide assembly, such aberrations including as field curvature and spherical aberrations, but also chromatic aberrations and others. In this manner, as shown in **Figure 9B****,** the problem of having a dispersed focal point can be remedied.

As also visible in Figs 9A and 9B, the distance of focal region from the focusing entity 51 may decrease with incident angle α becoming larger than 0°. Consequently, assuming a fixed distance between the focusing entity and the waveguide unit 71, the focusing region 6' may come to lie above the IL deflective area 31, such that the IL may not be reflected towards the inside of the waveguide unit. In order to address this problem, the present invention encompasses embodiments, where the position of the waveguide unit 71 along a vertical axis 9 is adjustable.

**Figure 10** shows an embodiment, in which the waveguide unit 71, preferably a waveguide subassembly 70, and even more preferably the waveguide layers 70, 80 comprising several waveguide subassemblies, are movable with respect to the focusing device 50, as illustrated by the double-headed arrow. In particular, a vertical and/or axial movement 95 is provided, which makes it possible to reduce and/or increase the distance D separating the waveguide subassembly 70 from the focusing device. In order to allow such a displacement, the invention may provide a support device, a motor and guiding elements (not shown), for conducting the relative movement. It is noted that there is no lateral displacement and the displacement as described does not result in a reduction of the surface that is available for capturing incident light.

**Figure 11** illustrates another embodiment suitable to make sure that the focal point falls on an IL deflective area 33 of a waveguide unit. In this embodiment, the light channel 23' extends from the junction region 46 in a direction that has a horizontal component as well as a vertical component. The waveguide unit 71.3 has thus preferably a structure, for example one or more arms 23', that are inclined and/or bent with respect to horizontal and/or which are not extending in parallel to horizontal. In a preferred embodiment, taken from proximal (at the junction) to distal (at the IL deflective area), the light channels and/or arms 23' of the waveguide unit are inclined and/or bent towards the focusing device 50. Preferably, the longer the extension of the light channel and/or arm 23', the closer the corresponding IL deflective area 33 is situated with respect to the focusing device 50.

**Figures 12** show a suitable support for the waveguide subassemblies of an assembly 102 as disclosed in Fig. 4B. The first and second subassemblies 70, 80 are positioned on a support plate 108. The plate 108 comprises a through hole or bore 109. The waveguide exit 87 is placed in the through hole, such that the collected, concentrated light can be transferred away through the hole. The waveguide units 71 of the first waveguide subassembly may be fixed, for example glued, on the arms 84 of the second waveguide subassembly 80. The arms 84 are preferably fixed, for example glued, on the support plate 108. As described with respect to Figs 14A and 14B below, the plate 108 is preferably rotatably integrated in a larger support structure.

**Figures 13A** and **13B** disclose another embodiment for providing a support of a waveguide unit and/or subassembly allowing a rotation in accordance with embodiments disclosed herein above, for example. Fig. 13B is a section through at line A-A of the disk 111 of Fig. 13A. In the embodiment shown, a waveguide unit 85 of a second waveguide subassembly 80 is formed inside a circular plate 111 comprising a waveguide material. The light channels 84' of the waveguide unit 85 are formed by machining and/or molding of a circular plate 111. In particular, grooves 112 are provided to extend substantially in a radial manner from the center or junction region 86' of the circular plate 111, so as to define the lateral walls 28', 29' of longitudinal light channels 84'. The grooves 112 also define the top wall 26' of the light channels, whereas the bottom wall 27' of the light channel is formed by the lower surface of the plate 111. Furthermore, the grooves do not extend entirely to the center of plate 111, but end in the proximity of the center, so as to define a junction region 86' at the center of plate 111, analogous to the junction region 86 of the second waveguide subassembly as described with respect to Fig. 4B. In contrast to the embodiment shown in Fig. 4B, the lateral walls 28', 29' of the second waveguide subassembly 85 of Figs 13A and 13B do not extend entirely through the entire thickness of the waveguide unit 85, such that the unit 85 remains rigidly connected with plate 111 by way of material bridges 113, which here are provided on the lower side of the plate 111. The waveguide units 71 of the first waveguide subassembly 70 (not shown in Figs 13A and 13B) may be fixed, at the appropriate position, preferably, above the IL deflective areas 83', at the distal extremities of the light channels 84' of the waveguide unit 85. It is noted that both embodiments, disclosed in Figs 12 to 13B, comprise a substantially circular support structure 108 or 111, respectively, which may be integrated in a rotating mechanism in accordance with embodiments requiring a rotational waveguide subassembly.

**Figures 14A** and **14B** show a mechanical arrangement in the form a device 130, which allows the rotation of the focusing device 50 and the waveguide subassemblies or waveguide layers 70, 80.

The device 130 comprises the assembly 102 shown in Fig. 4B. The device further comprises a frame plate 120, on which rollers 125 are provided, which are engaged with a circumferential groove 126 of a hollow cylindrical or annular part 121, which may also be considered as a housing. As can be seen in Fig. 14A, first and second waveguide layers 70, 80 are carried inside the part 121, with the waveguide exit 87 of the second layer 80 extending through a hole in carrier plate 108, as disclosed in Fig. 12. The plate 108 is carried on an inner rim towards the lower end of the part 121. It is noted that only a single unit 71 of the first waveguide subassembly 70 is shown in Fig. 14A for illustration.

At the top of the part 121, a circular plate 122 is provided, comprising a focusing device 50 in the form of an array of focusing entities 51, 52, etc. A circumferential toothed rail 131 is provided on the outer surface of the housing 121. A motor 133 is preferably provided on the plate 120. The motor wheel 132 is geared with the toothed rail 131 so as to allow for the rotation of the entire part 121, the waveguide layers 70, 80 and the focusing device 50.

The device 130 allows for collecting and concentrating light impinging on the focusing device 50 within an incident angle range covering nearly 180° (±90°). The rotation of the housing allows directing the incident light via the focusing entities 51, 52, etc, towards a corresponding IL deflecting area or to a transfer module of a waveguide unit, as disclosed elsewhere in this specification, e.g. in Fig. 6B. Light that is collected and concentrated by the waveguide subassemblies of the device 130 is transferred to a waveguide exit 87, from where it can be further transferred, for example for further concentration or any desired use.

The rotation of the focusing device is preferably an in-plane rotation, provided to take place in a plane 8 that has a position that is fixed relative to the light collecting assembly, preferably fixed with respect to the entire device 130. This feature distinguishes the invention from the prior art, which discloses rotation about several rotation axes and/or out of plane rotation for the purpose of solar tracking.

In the embodiment of Figs 14A-14B, the hollow cylindrical or annular part 121 carries the focusing device 50 and more precisely the plate 122 in which the focusing device is provided. In this embodiment, the focusing device rotates with the hollow cylindrical and/or annular part 121.

In an embodiment, the light collecting assembly comprises a cover (not shown), which is provided above the focusing device or preferably between the focusing device and incident light 1. The cover is preferably transparent plastic plate or curved plate that lets incident light into the system, while protecting the assembly from various harmful impacts, in particular from environmental factors, such as aging from the UV part of the spectrum, dust accumulation, mechanical impacts from animals or harsh weather conditions. The cover might also provide hermetic protection for the mechanism against rain or other sources of water. Regarding the UV protection, the cover may, in some embodiments, block UV light in order to protect the system from the aging. In other embodiments, the cover may be transparent for UV light so that the system is also adapted to harvest the UV part of the spectrum.

**Figures 15** and **16** show embodiments that can be seen as extensions and/or alternatives to the implementation shown in Fig. 3. Regarding first Fig. 15, the assembly 103 comprises a multiple of the focusing entities 51, 52, etc, of the assembly 102 shown in Fig. 3, which focusing entities may be considered as a single or several separate focusing devices 50. Accordingly, the assembly 103 comprises also a multiple of the amount of waveguide units 71, 72, etc., in the first waveguide subassembly 70, as there is preferably at least one waveguide unit for capturing the focused light provided by a given focusing entity 51. The second waveguide subassembly 80 comprises two separate waveguide units 81, 82, which are constructed as described with respect to waveguide unit 81 shown in Fig. 3. Each of the two waveguide units 81 and 82 of the second waveguide subassembly 80 produces an own transfer light beam 15, such that there are two transfer light beams provided by the second waveguide subassembly. The device shown in Fig. 15 comprises a third waveguide subassembly 90, provided to receive the (at least) two TL light beams 15 of the preceding, second waveguide subassembly 80.

The third waveguide subassembly 90 comprises preferably at least one waveguide unit 99, comprising one, two or more IL deflective areas 93 provided to receive each a transferring light beam 15 provided by a waveguide unit 81, 82, respectively, of the second waveguide subassembly 80. As described with respect to previous embodiments, the waveguide unit 99 comprises one or more light channels, each light channel reaching from a (distal) IL deflective area to the TL deflective area 98 provided at a junction region 96 of the waveguide unit 99.

It is noted that Figs 3 and 15 show schematic, 2D arrangements. As can be seen in Fig. 4B, the invention encompasses a 3D arrangement, where light channels of a given waveguide subassembly are arranged in a star like manner, extending in different directions, preferably within a given plane for a particular waveguide subassembly. Accordingly, while Fig. 15 shows six (6) transfer light beams 5 directed to each of the two waveguide units 81, 82 of the second subassembly 80, and two TL beams 15 exiting the second subassembly for being received by the third subassembly 90, these numbers are arbitrary. In particular, the second waveguide subassembly (or layer) 80 may well comprise more than two waveguide units, for example up to 100, up to 50 or up to 10 waveguide units, resulting in the corresponding number of transferring light beams 15 provided by the second waveguide subassembly and received by the third waveguide layer 90.

Figure 15, as Fig. 3, illustrates the layered disposition of waveguides, where the terms "subassembly" and "layer" may be used interchangeably. The layered disposition, in a direction from incoming light at the focusing device through the various waveguide layers results in an increasing light concentration and thus light intensity output at the respective waveguide exit, as each layer concentrates light of waveguide units of the previous waveguide layer. In some embodiments, the invention provides a branched, arborescent and/or pyramidal arrangement of waveguide layers, with increasing light concentration/intensity towards the root of the arborescent structure, as light originating from an increasing area is preferably concentrated in fewer and fewer waveguide exits.

**Figure 16** is another embodiment of a light collecting assembly 104, illustrating the modularity enabled by the concept of the invention. The assembly 104 comprises a first waveguide subassembly 70 and a second waveguide subassembly 80', which has a relatively wide extension and receives light transferred from the first waveguide subassembly as previously described, and also focused light 2 provided by the focusing device 50. Indeed, some focusing entities provide focused light to waveguide units 71 of the first waveguide subassembly, while other focusing entities provide focused light that is received by the second waveguide subassembly.

While certain of the preferred embodiments of the present invention have been described and specifically exemplified above, it is not intended that the invention be limited to such embodiments. Various modifications may be made thereto without departing from the scope of the present invention, as set forth in the following claims.

## Claims

1. A light collecting assembly (100,101,102,103,104) comprising:
- a focusing device (50) comprising a focusing entity (51) provided to receive external light (1) and focus said external light to provide focused light (2);
- a first waveguide subassembly (70) comprising a waveguide unit (71,72,73,74,75,76) provided to receive said focused light, wherein said waveguide unit (71,72,73,74,75,76) comprises light deflective areas (31,32,33,34,35,36,37) comprising:
- a group of incoming light, IL, deflective areas (31,32,33,34) provided to receive and deflect said focused light (2) so as to provide propagated light (3) that is propagated within said waveguide unit (71,72,73,74,75,76);
- one or more transferring light, TL, deflective area (36, 37) provided to deflect said propagated light so as to provide a transfer light beam (5) leaving said waveguide unit (71,72,73,74,75,76);
wherein said waveguide unit (71,72,73,74,75,76) preferably comprises a junction region (46) and/or an exit region (47), wherein said waveguide unit is suitable to provide said transfer light beam (5) passing through said junction region and/or exit region to leave said waveguide unit;
wherein one or both selected from said first waveguide subassembly (70) and said focusing device (50) is provided rotational in said light collecting assembly, and wherein single-axis rotation, optionally in combination with a linear movement (95) changing a distance, D, between said waveguide subassembly and said focusing device, is provided for solar light tracking;
**characterized in that**
said waveguide unit (71,72,73,74,75,76) is provided so that, at a time, said focused light is received by: I only one IL deflective area (31) selected from said group of IL deflective areas (31,32,33,34), II said junction region, or III none of the IL deflective areas (31,32,33,34) nor said junction region, **and in that**
said IL deflective areas are provided such that a rotational position of said first waveguide subassembly (70) and/or said focusing device (50), is adjustable to determine if said focused light is received by: I said only one IL deflective area (31), II said junction region, or III none of said IL deflective areas (31,32,33,34) nor said junction region, and, in case said focused light is received by said only one IL deflective area, which IL deflective area of said group of IL deflective areas is said only one receiving said focused light.

2. The light collecting assembly of claim 1, wherein said single-axis rotation, optionally in combination with said linear movement, enables solar light tracking over an incident light angle range of 30° or more, wherein said 30° or more range encompasses light having an incident angle α of 15°.

3. The light collecting assembly of any one of the preceding claims, wherein said one IL deflective area receiving said focused light from said focusing entity (51) is determined by said rotational position of said first waveguide subassembly (70) and further in dependence of the incident light angle α.

4. The light collecting assembly of any one of the preceding claims, wherein said focusing entity comprises a lens with a part of the lens that possesses axial symmetry and/or wherein said lens exhibits more than 2-fold discrete rotational symmetry.

5. The light collecting assembly of any one of the preceding claims, wherein an axis (9) of rotation of one or both selected from said first waveguide subassembly (70) and said focusing device (50) is substantially normal to the overall light collecting assembly (100) and/or to first and second opposed sides of said first waveguide subassembly (70).

6. The light collecting assembly of any one of the preceding claims, which is configured to conduct a rotational movement depending on an incident angle α, β, ··· or angle range of external light (1), wherein said rotational movement is provided to be conducted until a focus region (6) of said focused light (2) is positioned with respect to said one IL deflective area of said group of IL deflective elements comprised in a waveguide unit in such a manner that said one IL deflective area effectively deflects said focused light into a medium of said waveguide unit (71).

7. The light collecting assembly (100) of any one of the preceding claims, wherein said group of IL deflective areas (31,32,33,34) comprises separate IL deflective areas (31,32,33,34) provided at separate positions with respect to said waveguide unit (71,72,73,74,75,76), wherein said positions are selected such that light impinging on said light focusing device (50, 60) at different incident angles α, β, ... or angle ranges is focused towards said one of said IL deflective areas (31,32,33,34), depending on the incident angle.

8. The light collecting assembly (100) of any one of the preceding claims, wherein said waveguide unit (71,72,73,74,75,76) comprises a plurality of non-overlapping light channels (21,22,23,24), each light channel extending from one IL deflective area to a TL deflective area, wherein said light channels (21,22,23,24) extend radially from said junction region (46) and wherein said waveguide unit (71,72,73,74,75,76) comprises light channels having different lengths and extending in different directions, and preferably wherein said light channels (21,22,23,24) are provided in the form of arms consisting essentially of a waveguide medium, said arms being joined at said junction region (46).

9. The light collecting assembly (100) of any one of the preceding claims, wherein each waveguide unit (71,72,73,74,75,76) comprises one or more waveguide exit (47) providing a transfer light beam (5), wherein said first waveguide subassembly (70) comprises a plurality of waveguide units (71,72,73,74,75,76), and wherein said focusing device comprises a plurality of focusing entities (51,52,53,54,55,56), so that said first waveguide subassembly (70) is arranged to provide a plurality of transfer light beams (5) for transferring light received via separate focusing entities propagated in separate waveguide units (71,72,73,74,75,76).

10. The light collecting assembly (100) of any one of the preceding claims, wherein said assembly (100) comprises a second waveguide subassembly (80), said second waveguide subassembly being provided to receive two or more transfer light beams (5) provided by said first waveguide subassembly (70).

11. The light collecting assembly (100) of claim 10, wherein said first waveguide subassembly (70) comprises a plurality of waveguide units (71,72,73,74,75,76), each waveguide unit providing one or more transfer light beams (5, 5.1, 5.2, ...), wherein said second waveguide subassembly (80) is provided to receive two or more transfer light beams (5) provided by two or more waveguide units (71,72,73,74,75,76), respectively, of said first waveguide subassembly (70).

12. A method for operating the light collecting assembly of any one of claims 1-11, the method comprising conducting a single-axis rotational movement of said focusing device (50) and/or of said first waveguide subassembly (70) around an axis (9), optionally in combination with a linear movement (95) of said first waveguide subassembly (70) along said axis (9), for solar light tracking.

13. The method of claim 12, wherein said rotational movement is conducted so as to direct said focused light (2) to one or more of said incoming light, IL, deflective areas (31,32,33,34), and so as to thereby preferably maximize the transfer of external light (1) through said first waveguide subassembly (70) and/or said second waveguide subassembly (80).

14. The method of claim 12, wherein said rotational movement is conducted so as to direct said focused light (2) away from said incoming light, IL, deflective areas (31,32,33,34), so as to thereby let the light pass through the light collecting assembly and/or minimizing the redirection of light through said first waveguide subassembly (70) and/or said second waveguide subassembly (80).

15. The method of any one of claims 12-14, wherein said rotational movement comprises one or more selected from:
- a rotation of both, said focusing device and said first waveguide subassembly (70), preferably by co-rotation around said axis (9);
- a rotation of one selected from said focusing device and said first waveguide subassembly (70) with respect to the other, said first waveguide subassembly (70) and focusing device, respectively.

## Patentansprüche

1. Eine Lichtsammlungsanordnung (100,101,102,103,104), umfassend:
- eine Fokussiervorrichtung (50) mit einer Fokussiereinheit (51), die dazu eingerichtet ist, externes Licht (1) zu empfangen und dieses externe Licht zu fokussieren, um fokussiertes Licht (2) bereitzustellen;
- eine erste Wellenleiter-Untereinheit (70) mit einer Wellenleitereinheit (71,72,73,74,75,76), die dazu eingerichtet ist, das fokussierte Licht zu empfangen, wobei die Wellenleitereinheit (71,72,73,74,75,76) lichtablenkende Bereiche (31,32,33,34,35,36,37) umfasst, umfassend:
- eine Gruppe von einfallendem Licht, EL, ablenkenden Bereichen (31,32,33,34), die dazu eingerichtet sind, das fokussierte Licht (2) zu empfangen und abzulenken, um propagierendes Licht (3) bereitzustellen, das innerhalb der Wellenleitereinheit propagiert wird;
- einen oder mehrere übertragendes Licht, ÜL, ablenkende Bereiche (36, 37), die dazu eingerichtet sind, das propagierte Licht abzulenken, um einen Übertragungslichtstrahl (5) bereitzustellen, der die Wellenleitereinheit (71,72,73,74,75,76) verlässt;
wobei die Wellenleitereinheit (71,72,73,74,75,76) vorzugsweise eine Verbindungsregion (46) und/oder eine Austrittsregion (47) umfasst, wobei die Wellenleitereinheit dazu geeignet ist, den Übertragungslichtstrahl (5) bereitzustellen, der durch die Verbindungsregion und/oder Austrittsregion hindurchtritt, um die Wellenleitereinheit zu verlassen;
wobei die erste Wellenleiter-Untereinheit (70) und/oder die Fokussiervorrichtung (50) drehbar in der Lichtsammlungsanordnung angeordnet ist/sind und wobei eine einachsige Rotation, optional in Kombination mit einer linearen Bewegung (95), die einen Abstand D zwischen der Wellenleiter-Untereinheit und der Fokussiervorrichtung verändert, zum Tracking von Sonnenlicht vorgesehen ist;
**dadurch gekennzeichnet, dass**
die Wellenleitereinheit (71,72,73,74,75,76) so ausgestaltet ist, dass zu einem bestimmten Zeitpunkt, das fokussierte Licht empfangen wird von: I genau einem EL-ablenkenden Bereich (31) aus der Gruppe der EL-ablenkenden Bereiche (31,32,33,34), II der Verbindungsregion, oder III keinem der EL-ablenkenden Bereiche (31,32,33,34) und auch nicht von der Verbindungsregion,
**und dadurch, dass**
- die EL-ablenkenden Bereiche so angeordnet sind, dass eine Rotationsstellung der ersten Wellenleiter-Untereinheit (70) und/oder der Fokussiervorrichtung (50) einstellbar ist, um zu bestimmen, ob das fokussierte Licht empfangen wird von: I dem genau einen EL-ablenkenden Bereich (31), II der Verbindungsregion, oder III keinem der EL-ablenkenden Bereiche (31,32,33,34) und auch nicht von der Verbindungsregion, und, falls das fokussierte Licht von genau einem EL-ablenkenden Bereich empfangen wird, welcher EL-ablenkende Bereich von der Gruppe der EL ablenkenden Bereiche der genau eine EL-ablenkende Bereich ist.

2. Die Lichtsammlungsanordnung nach Anspruch 1, wobei die einachsige Rotation, optional in Kombination mit der linearen Bewegung, ein Tracking von Sonnenlicht über einen Einfallswinkelbereich von 30° oder mehr ermöglicht, wobei dieser Bereich Licht mit einem Einfallswinkel α von 15° umfasst.

3. Die Lichtsammlungsanordnung nach einem der vorhergehenden Ansprüche, wobei der eine EL-ablenkende Bereich, der das fokussierte Licht von der Fokussiereinheit (51) empfängt, durch die Rotationsstellung der ersten Wellenleiter-Untereinheit (70) und zusätzlich in Abhängigkeit vom Einfallswinkel α bestimmt wird.

4. Die Lichtsammlungsanordnung nach einem der vorhergehenden Ansprüche, wobei die Fokussiereinheit eine Linse umfasst mit einem Teil der Linse, der eine axiale Symmetrie aufweist, und/oder wobei die Linse eine mehr als zweifache diskrete Rotationssymmetrie aufweist.

5. Die Lichtsammlungsanordnung nach einem der vorhergehenden Ansprüche, wobei eine Rotationsachse (9) der ersten Wellenleiter-Untereinheit (70) und/oder der Fokussiervorrichtung (50) im Wesentlichen senkrecht zur gesamten Lichtsammlungsanordnung (100) und/oder zu ersten und zweiten gegenüberliegenden Seiten der ersten Wellenleiter-Untereinheit (70) verläuft.

6. Die Lichtsammlungsanordnung nach einem der vorhergehenden Ansprüche, die so konfiguriert ist, dass eine Rotationsbewegung in Abhängigkeit von einem Einfallswinkel α, β, ... oder einem Winkelbereich des externen Lichts (1) durchgeführt wird, wobei die Rotationsbewegung so ausgeführt wird, dass eine Fokusregion (6) des fokussierten Lichts (2) relativ zu dem einen EL-ablenkenden Bereich so positioniert wird, dass dieser EL-ablenkende Bereich das fokussierte Licht effektiv in ein Medium der Wellenleitereinheit (71) ablenkt.

7. Die Lichtsammlungsanordnung (100) nach einem der vorhergehenden Ansprüche, wobei die besagte Gruppe von EL-ablenkenden Bereichen (31,32,33,34) getrennte EL-ablenkende Bereiche umfasst, die an verschiedenen Positionen relativ zur Wellenleitereinheit (71,72,73,74,75,76) angeordnet sind, wobei diese Positionen so gewählt sind, dass Licht, das mit unterschiedlichen Einfallswinkeln α, β, ... oder Winkelbereichen auf besagte Fokussiervorrichtung (50, 60) auftritt, in Abhängigkeit vom Einfallswinkel auf jeweils einen der EL-ablenkenden Bereiche fokussiert wird.

8. Die Lichtsammlungsanordnung (100) nach einem der vorhergehenden Ansprüche, wobei die Wellenleitereinheit (71,72,73,74,75,76) mehrere, nicht überlappende Lichtkanäle (21,22,23,24) umfasst, die jeweils von einem EL-ablenkenden Bereich zu einem ÜL-ablenkenden Bereich verlaufen, wobei besagte Lichtkanäle (21,22,23,24) radial von der Verbindungsregion (46) ausgehen und wobei die besagte die Wellenleitereinheit (71,72,73,74,75,76) Lichtkanäle mit unterschiedlichen Längen und Richtungen aufweist, und wobei besagte Lichtkanäle (21,22,23,24) vorzugsweise in Form von Armen, die im Wesentlichen aus einem Wellenleitermedium bestehen, ausgebildet sind, wobei besagte Arme an der Verbindungsregion (46) zusammengeführt sind.

9. Die Lichtsammlungsanordnung (100) nach einem der vorhergehenden Ansprüche, wobei jede Wellenleitereinheit (71,72,73,74,75,76) einen oder mehrere Wellenleiter-Ausgänge (47) umfasst, die einen Übertragungslichtstrahl bereitstellen, wobei die erste Wellenleiter-Untereinheit (70) eine Mehrzahl von Wellenleitereinheiten (71,72,73,74,75,76) umfasst, und wobei die Fokussiervorrichtung eine Mehrzahl von Fokussiereinheiten (51,52,53,54,55,56) umfasst, sodass die besagte erste Wellenleiter-Untereinheit (70) so ausgebildet ist, dass eine Mehrzahl von Übertragungslichtstrahlen (5) bereitgestellt wird, damit Licht, dass von separaten Fokussiereinheiten empfangen wird, in verschiedenen Wellenleitereinheiten (71,72,73,74,75,76) übertragen wird.

10. Die Lichtsammlungsanordnung (100) nach einem der vorhergehenden Ansprüche, umfassend eine zweite Wellenleiter-Untereinheit (80), die dazu eingerichtet ist, zwei oder mehr Übertragungslichtstrahlen (5), die von der ersten Wellenleiter-Untereinheit (70) bereitgestellt werden, aufzunehmen.

11. Die Lichtsammlungsanordnung (100) nach Anspruch 10, wobei die erste Wellenleiter-Untereinheit (70) eine Mehrzahl von Wellenleitereinheiten (71,72,73,74,75,76) umfasst, wobei jede Wellenleitereinheit einen oder mehrere Übertragungslichtstrahlen (5, 5.1, 5.2, ...) bereitstellt, wobei die besagte zweite Wellenleiter-Untereinheit (80) zwei oder mehr von den Übertragungslichtstrahlen, die jeweils von zwei oder mehr Wellenleitereinheiten (71,72,73,74,75,76) bereitgestellt werden, empfängt.

12. Verfahren zum Betreiben der Lichtsammlungsanordnung nach einem der Ansprüche 1-11, umfassend das Ausführen einer einachsigen Rotationsbewegung der Fokussiervorrichtung (50) und/oder der ersten Wellenleiter-Untereinheit (70) um eine Achse (9), optional kombiniert mit einer linearen Bewegung (95) der ersten Wellenleiter-Untereinheit (70) entlang dieser Achse zum Tracking des Sonnenlichts.

13. Das Verfahren nach Anspruch 12, wobei die Rotationsbewegung so durchgeführt wird, dass das fokussierte Licht derart auf einen oder mehrere EL-ablenkende Bereiche (31,32,33,34) gerichtet wird, dass die Übertragung des externen Lichts (1) durch die erste Wellenleiter-Untereinheit (70) und/oder besagte zweite Wellenleiter-Untereinheit (80) maximiert wird.

14. Das Verfahren nach Anspruch 12, wobei die Rotationsbewegung so durchgeführt wird, dass das fokussierte Licht (2) von dem einen oder mehreren EL-ablenkenden Bereichen (31,32,33,34) weggerichtet wird, um dadurch ein Durchlassen des Lichts durch die Lichtsammlungsanordnung zu ermöglichen und/oder um die Umlenkung des Lichts durch die besagte erste Wellenleiter-Untereinheit (70) und/oder besagte zweite Wellenleiter-Untereinheit (80) zu minimieren.

15. Das Verfahren nach einem der Ansprüche 12-14, wobei die besagte Rotationsbewegung eines oder mehrere der folgenden umfasst:
- eine Drehung von beiden, der Fokussiervorrichtung und der ersten Wellenleiter-Untereinheit (70), vorzugsweise durch Mitrotation um die besagte Achse (9); oder
- eine Drehung von jeweils einem ausgewählt von besagter Fokussiervorrichtung und besagter ersten Wellenleiter-Untereinheit (70) um das jeweils andere, die besagte ersten Wellenleiter-Untereinheit (70) oder die besagter Fokussiervorrichtung.

## Revendications

1. Ensemble collecteur de lumière (100,101,102,103,104) comprenant :
- un dispositif de focalisation (50) comprenant une entité de focalisation (51) prévue pour recevoir de la lumière externe (1) et focaliser ladite lumière externe pour fournir de la lumière focalisée (2) ;
- un premier sous-ensemble de guide d'ondes (70) comprenant une unité de guide d'ondes (71,72,73,74,75,76) prévue pour recevoir ladite lumière focalisée, dans lequel ladite unité de guide d'ondes (71,72,73,74,75,76) comprend des zones déviatrices de lumière (31,32,33,34,35,36,37) comprenant :
- un groupe de zones déviatrices de lumière entrante, LE, (31,32,33,34) prévues pour recevoir et dévier ladite lumière focalisée (2) de manière à fournir de la lumière propagée (3) qui est propagée à l'intérieur de ladite unité de guide d'ondes (71,72,73,74,75,76) ;
- une ou plusieurs zones déviatrices de lumière de transfert, LT, (36, 37) prévues pour dévier ladite lumière propagée de manière à fournir un faisceau de lumière de transfert (5) quittant ladite unité de guide d'ondes (71,72,73,74,75,76) ;
ladite unité de guide d'ondes (71,72,73,74,75,76) comprenant de préférence une région de jonction (46) et/ou une région de sortie (47), ladite unité de guide d'ondes étant appropriée pour fournir ledit faisceau de lumière de transfert (5) traversant ladite région de jonction et/ou ladite région de sortie pour quitter ladite unité de guide d'ondes ;
l'un ou les deux choisis parmi ledit premier sous-ensemble de guide d'ondes (70) et ledit dispositif de focalisation (50) étant prévu(s) rotatif(s) dans ledit ensemble collecteur de lumière, et une rotation sur un seul axe, éventuellement en combinaison avec un mouvement linéaire (95) modifiant une distance, D, entre ledit sous-ensemble de guide d'ondes et ledit dispositif de focalisation, étant prévue pour le suivi de la lumière solaire ;
**caractérisé en ce que** ladite unité de guide d'ondes (71,72,73,74,75,76) est prévue de sorte que, à un instant donné, ladite lumière focalisée est reçue par : I une seule zone déviatrice de LE (31) choisie parmi ledit groupe de zones déviatrices de LE (31,32,33,34), II ladite région de jonction, ou III aucune des zones déviatrices de LE (31,32,33,34) ni ladite région de jonction, **et en ce que** lesdites zones déviatrices de LE sont prévues de telle sorte qu'une position de rotation dudit premier sous-ensemble de guide d'ondes (70) et/ou dudit dispositif de focalisation (50) soit ajustable pour déterminer si ladite lumière focalisée est reçue par : I ladite seule zone déviatrice LE (31), II ladite région de jonction, ou III aucune desdites zones déviatrices de LE (31,32,33,34) ni ladite région de jonction, et, dans le cas où ladite lumière focalisée est reçue par ladite seule zone déviatrice de LE, quelle zone déviatrice de LE dudit groupe de zones déviatrices de LE est ladite seule recevant ladite lumière focalisée.

2. Ensemble collecteur de lumière selon la revendication 1, dans lequel ladite rotation sur un seul axe, éventuellement en combinaison avec ledit mouvement linéaire, permet un suivi de la lumière solaire sur une plage d'angles de lumière incidente de 30° ou plus, dans lequel ladite plage de 30° ou plus englobe de la lumière ayant un angle d'incidence α de 15°.

3. Ensemble collecteur de lumière selon l'une quelconque des revendications précédentes, dans lequel ladite une zone déviatrice de LE recevant ladite lumière focalisée depuis ladite entité de focalisation (51) est déterminée par ladite position de rotation dudit premier sous-ensemble de guide d'ondes (70) et en outre en fonction de l'angle de lumière incidente α.

4. Ensemble collecteur de lumière selon l'une quelconque des revendications précédentes, dans lequel ladite entité de focalisation comprend une lentille avec une partie de la lentille qui possède une symétrie axiale et/ou dans lequel ladite lentille présente une symétrie rotationnelle discrète d'ordre supérieur à 2.

5. Ensemble collecteur de lumière selon l'une quelconque des revendications précédentes, dans lequel un axe (9) de rotation de l'un ou des deux choisis parmi ledit premier sous-ensemble de guide d'ondes (70) et ledit dispositif de focalisation (50) est sensiblement normal à l'ensemble collecteur de lumière global (100) et/ou à des premier et deuxième côtés opposés dudit premier sous-ensemble de guide d'ondes (70).

6. Ensemble collecteur de lumière selon l'une quelconque des revendications précédentes, qui est configuré pour effectuer un mouvement de rotation en fonction d'un angle d'incidence α, β, ... ou d'une plage d'angles de la lumière externe (1), ledit mouvement de rotation étant prévu pour être effectué jusqu'à ce qu'une région focale (6) de ladite lumière focalisée (2) soit positionnée par rapport à ladite une zone déviatrice de LE dudit groupe d'éléments déviateurs de LE compris dans une unité de guide d'ondes de telle manière que ladite une zone déviatrice de LE dévie efficacement ladite lumière focalisée dans un milieu de ladite unité de guide d'ondes (71).

7. Ensemble collecteur de lumière (100) selon l'une quelconque des revendications précédentes, dans lequel ledit groupe de zones déviatrices de LE (31,32,33,34) comprend des zones déviatrices de LE séparées (31,32,33,34) prévues à des positions séparées par rapport à ladite unité de guide d'ondes (71,72,73,74,75,76), lesdites positions étant choisies de telle sorte que de la lumière frappant ledit dispositif de focalisation de lumière (50, 60) à différents angles d'incidence α, β, ... ou plages d'angles soit focalisée vers ladite une seule zones déviatrices de LE (31,32,33,34), en fonction de l'angle d'incidence.

8. Ensemble collecteur de lumière (100) selon l'une quelconque des revendications précédentes, dans lequel ladite unité de guide d'ondes (71,72,73,74,75,76) comprend une pluralité de canaux de lumière sans chevauchement (21,22,23,24), chaque canal de lumière s'étendant depuis une zone déviatrice de LE jusqu'à une zone déviatrice de LT, dans lequel lesdits canaux de lumière (21,22,23,24) s'étendent radialement depuis ladite région de jonction (46) et dans lequel ladite unité de guide d'ondes (71,72,73,74,75,76) comprend des canaux de lumière ayant des longueurs différentes et s'étendant dans des directions différentes, et de préférence dans lequel lesdits canaux de lumière (21,22,23,24) sont prévus sous la forme de bras constitués essentiellement d'un milieu de guide d'ondes, lesdits bras étant reliés au niveau de ladite région de jonction (46).

9. Ensemble collecteur de lumière (100) selon l'une quelconque des revendications précédentes, dans lequel chaque unité de guide d'ondes (71,72,73,74,75,76) comprend une ou plusieurs sorties de guide d'ondes (47) fournissant un faisceau de lumière de transfert (5), dans lequel ledit premier sous-ensemble de guide d'ondes (70) comprend une pluralité d'unités de guide d'ondes (71,72,73,74,75,76), et dans lequel ledit dispositif de focalisation comprend une pluralité d'entités de focalisation (51,52,53,54,55,56), de sorte que ledit premier sous-ensemble de guide d'ondes (70) est agencé pour fournir une pluralité de faisceaux de lumière de transfert (5) pour transférer de la lumière reçue via des entités de focalisation séparées propagée dans des unités de guide d'ondes séparées (71,72,73,74,75,76).

10. Ensemble collecteur de lumière (100) selon l'une quelconque des revendications précédentes, dans lequel ledit ensemble (100) comprend un deuxième sous-ensemble de guide d'ondes (80), ledit deuxième sous-ensemble de guide d'ondes étant prévu pour recevoir deux ou plusieurs faisceaux de lumière de transfert (5) fournis par ledit premier sous-ensemble de guide d'ondes (70).

11. Ensemble collecteur de lumière (100) selon la revendication 10, dans lequel ledit premier sous-ensemble de guide d'ondes (70) comprend une pluralité d'unités de guide d'ondes (71,72,73,74,75,76), chaque unité de guide d'ondes fournissant un ou plusieurs faisceaux de lumière de transfert (5, 5.1, 5.2, ...), dans lequel ledit deuxième sous-ensemble de guide d'ondes (80) est prévu pour recevoir deux ou plus que deux faisceaux de lumière de transfert (5) fournis par deux ou plus que deux unités de guide d'ondes (71,72,73,74,75,76), respectivement, dudit premier sous-ensemble de guide d'ondes (70).

12. Méthode pour faire fonctionner l'ensemble collecteur de lumière selon l'une quelconque des revendications 1 à 11, la méthode comprenant la réalisation d'un mouvement de rotation sur un seul axe dudit dispositif de focalisation (50) et/ou dudit premier sous-ensemble de guide d'ondes (70) autour d'un axe (9), éventuellement en combinaison avec un mouvement linéaire (95) dudit premier sous-ensemble de guide d'ondes (70) le long dudit axe (9), pour le suivi de la lumière solaire.

13. Méthode selon la revendication 12, dans laquelle ledit mouvement de rotation est effectué de manière à diriger ladite lumière focalisée (2) vers une ou plusieurs desdites zones déviatrices de lumière entrante, LE, (31,32,33,34), et de manière à ainsi de préférence maximiser le transfert de lumière externe (1) à travers ledit premier sous-ensemble de guide d'ondes (70) et/ou ledit deuxième sous-ensemble de guide d'ondes (80).

14. Méthode selon la revendication 12, dans laquelle ledit mouvement de rotation est effectué de manière à diriger ladite lumière focalisée (2) à l'écart desdites zones déviatrices de lumière entrante, LE, (31,32,33,34), de manière à ainsi laisser passer la lumière à travers l'ensemble collecteur de lumière et/ou à minimiser la redirection de lumière à travers ledit premier sous-ensemble de guide d'ondes (70) et/ou ledit deuxième sous-ensemble de guide d'ondes (80).

15. Méthode selon l'une quelconque des revendications 12 à 14, dans laquelle ledit mouvement de rotation comprend un ou plusieurs éléments choisis parmi :
- une rotation à la fois dudit dispositif de focalisation et dudit premier sous-ensemble de guide d'ondes (70), de préférence par co-rotation autour dudit axe (9) ;
- une rotation de l'un choisi parmi ledit dispositif de focalisation et ledit premier sous-ensemble de guide d'ondes (70) par rapport à l'autre, dudit premier sous-ensemble de guide d'ondes (70) et dudit dispositif de focalisation, respectivement.
